(19) Europäisches Patentamt
European Patent Office
Office européen des brevets

(11) **EP 3 320 401 B1**

(12) **EUROPÄISCHE PATENTSCHRIFT**

(45) Veröffentlichungstag und Bekanntmachung des Hinweises auf die Patenterteilung:
**05.02.2020 Patentblatt 2020/06**

(51) Int Cl.:
**G03F 7/20** *(2006.01)* **G02B 26/08** *(2006.01)*

(21) Anmeldenummer: **16736851.3**

(22) Anmeldetag: **07.07.2016**

(86) Internationale Anmeldenummer:
**PCT/EP2016/066105**

(87) Internationale Veröffentlichungsnummer:
**WO 2017/005849 (12.01.2017 Gazette 2017/02)**

(54) **LITHOGRAPHIEANLAGE UND VERFAHREN ZUM BETREIBEN EINER LITHOGRAPHIEANLAGE**

LITHOGRAPHY APPARATUS AND METHOD FOR OPERATING A LITHOGRAPHY APPARATUS

INSTALLATION LITHOGRAPHIQUE ET PROCÉDÉ DE FONCTIONNEMENT D'UNE INSTALLATION LITHOGRAPHIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.07.2015 DE 102015212658**

(43) Veröffentlichungstag der Anmeldung:
**16.05.2018 Patentblatt 2018/20**

(73) Patentinhaber: **Carl Zeiss SMT GmbH**
**73447 Oberkochen (DE)**

(72) Erfinder:
• **DINGER, Udo**
**73447 Oberkochen (DE)**
• **HOLZ, Markus**
**73431 Aalen (DE)**
• **BIHR, Ulrich**
**73467 Kirchheim / Dirgenheim (DE)**

(74) Vertreter: **Horn Kleimann Waitzhofer Patentanwälte PartG mbB**
**Ganghoferstrasse 29a**
**80339 München (DE)**

(56) Entgegenhaltungen:
**US-A1- 2008 079 930** **US-A1- 2009 117 494**
**US-A1- 2009 262 324** **US-A1- 2014 226 141**

**Beschreibung**

Die vorliegende Erfindung betrifft eine Lithographieanlage und ein Verfahren zum Betreiben einer Lithographieanlage. Die Lithographieanlage umfasst eine Strahlungsquelle zur Erzeugung einer Strahlung mit einer bestimmten Repetitionsfrequenz, ein optisches Bauteil, zum Beispiel einen Spiegel, zur Führung der Strahlung in der Lithographieanlage, eine Aktuator-Einrichtung zur Verlagerung des optischen Bauteils und eine Mess-Einrichtung zum Ermitteln einer Position des optischen Bauteils.

Die Mikrolithographie wird zur Herstellung mikrostrukturierter Bauelemente, wie beispielsweise integrierter Schaltkreise, angewendet. Der Mikrolithographieprozess wird mit einer Lithographieanlage durchgeführt, welche ein Beleuchtungssystem und ein Projektionssystem aufweist. Das Bild einer mittels des Beleuchtungssystems beleuchteten Maske (Retikel) wird hierbei mittels des Projektionssystems auf ein mit einer lichtempfindlichen Schicht (Photoresist) beschichtetes und in der Bildebene des Projektionssystems angeordnetes Substrat (z. B. ein Siliziumwafer) projiziert, um die Maskenstruktur auf die lichtempfindliche Beschichtung des Substrats zu übertragen.

Getrieben durch das Streben nach immer kleineren Strukturen bei der Herstellung integrierter Schaltungen werden derzeit EUV-Lithographieanlagen entwickelt, welche Licht mit einer Wellenlänge im Bereich von 0,1 nm bis 30 nm, insbesondere von 4 nm bis 6 nm, verwenden. Bei solchen EUV-Lithographieanlagen müssen wegen der hohen Absorption der meisten Materialien von Licht dieser Wellenlänge reflektierende Optiken, das heißt Spiegel, anstelle von - wie bisher - brechenden Optiken, das heißt Linsen, eingesetzt werden. Aus gleichem Grund ist die Strahlformung und Strahlprojektion in einem Vakuum durchzuführen.

Die Spiegel können z. B. an einem Tragrahmen (Engl.: force frame) befestigt und wenigstens teilweise manipulierbar oder verkippbar ausgestaltet sein, um eine Bewegung eines jeweiligen Spiegels in bis zu sechs Freiheitsgraden und damit eine hochgenaue Positionierung der Spiegel zueinander, insbesondere im pm-Bereich, zu ermöglichen. Somit können etwa im Betrieb der Lithographieanlage auftretende Änderungen der optischen Eigenschaften, z. B. infolge von thermischen Einflüssen, ausgeregelt werden.

Für das Verfahren der Spiegel, insbesondere in den sechs Freiheitsgraden, sind diesen Aktuatoren zugeordnet, welche über einen Regelkreis angesteuert werden. Als Teil des Regelkreises ist eine Vorrichtung zur Überwachung des Kippwinkels eines jeweiligen Spiegels vorgesehen.

Beispielsweise aus der WO 2009/100856 A1 ist ein Facettenspiegel für eine Projektionsbelichtungsanlage einer Lithographieanlage bekannt, welche eine Vielzahl von individuell verlagerbaren Einzelspiegeln aufweist. Um die optische Qualität einer Projektionsbelichtungsanlage sicherzustellen, ist eine sehr präzise Positionierung der verlagerbaren Einzelspiegel notwendig.

Ferner beschreibt das Dokument DE 10 2013 209 442 A1, dass der Feldfacettenspiegel als mikroelektromechanisches System (Micro-Electro-Mechanical System, MEMS) ausgebildet sein kann. Allerdings kann durch die Photonen der EUV-Strahlungsquelle der Lithographieanlage im Restgas im Beleuchtungssystem einerseits gepulstes Plasma erzeugt werden und andererseits durch den Photoeffekt Elektronen aus den Spiegeloberflächen der MEMS-Spiegel ausgelöst werden. Dadurch kann es zu zeitlich und räumlich variierenden Stromflüssen über die MEMS-Spiegel des Feldfacettenspiegels kommen. Diese zeitlich und räumlich variierenden Stromflüsse über die MEMS-Spiegel kann die Auswerteelektronik der Vorrichtung zur Überwachung des Kippwinkels des jeweiligen Spiegels empfindlich stören.

Des Weiteren beschreibt das Dokument US 2014/0226141 A1 ein herkömmliches mikrolithographisches Beleuchtungssystem. Ferner zeigen die Dokumente US 2008/079930 A1 und US 2009/262324 A1 herkömmliche mikrolithographische Beleuchtungssysteme mit Strahlungsquellen, optischen Bauteilen, Aktuator-Einrichtungen und Messeinrichtungen.

Vor diesem Hintergrund besteht eine Aufgabe der vorliegenden Erfindung darin, eine verbesserte Lithographieanlage zu schaffen.

Demgemäß wird eine Lithographieanlage vorgeschlagen, welche eine Strahlungsquelle zur Erzeugung einer Strahlung mit einer bestimmten Repetitionsfrequenz, ein optisches Bauteil zur Führung der Strahlung in der Lithographieanlage, eine Aktuator-Einrichtung zur Verlagerung des optischen Bauteils, eine Mess-Einrichtung zum Ermitteln einer Position des optischen Bauteils mittels eines Messsignals mit einer bestimmten Messsignalfrequenz aufweist, wobei die Messsignalfrequenz ungleich der Repetitionsfrequenz und ungleich ganzzahligen Vielfachen der Repetitionsfrequenz ist, und eine Einstell-Einrichtung aufweist, welche dazu eingerichtet ist, die Messsignalfrequenz in Abhängigkeit von der Repetitionsfrequenz einzustellen.

Die von der Strahlungsquelle erzeugte Strahlung kann mit ihren energiereichen Photonen zu einem Ladungstransfer auf das optische Bauteil oder von dem optischen Bauteil weg führen. Dieser Ladungstransfer kann insbesondere bei einem elektromechanisch aktuierbar verlagerbaren optischen Bauteil zu einer mechanischen Anregung desselben führen. Mit anderen Worten, das optische Bauteil kann durch die Beaufschlagung mit Strahlung mechanisch angeregt und/oder gestört werden. Insbesondere können hochenergetische Photonen von der Strahlungsquelle, insbesondere EUV-Photonen, zur Erzeugung eines Plasmas, insbesondere eines Wasserstoffplasmas, führen. Alternativ können Argon (Ar) oder Helium (He) als Spülgas verwendet werden. Dabei können dann beispielsweise Sauerstoff (O) und Stickstoff (N) als Beimischungen eingesetzt werden.

Dadurch, dass die Messsignalfrequenz der Mess-Einrichtung ungleich der Repetitionsfrequenz der Strahlungsquelle und ungleich den ganzzahligen Vielfachen der Repetitionsfrequenz ist, ist die Mess-Einrichtung vorteilhafterweise desensibilisiert. Die Mess-Einrichtung ist insbesondere gegenüber Strompulsen desensibilisiert, welche aufgrund der verwendeten Wellenlängen, zum Beispiel 0,1 nm bis 30 nm, der Strahlungsquelle durch aus der Oberfläche des optischen Bauteils oder dem Plasma ausgelösten Ladungsträgern erzeugt werden.

Bei dem verlagerbaren optischen Bauteil kann es sich insbesondere um einen Spiegel, insbesondere um einen Mikrospiegel, d.h. einen Spiegel mit einer Seitenlänge von weniger als 1 mm handeln. Der Spiegel oder Mikrospiegel kann insbesondere Bestandteil einer Vielspiegel-Anordnung (Multi-Mirror Array, MMA) sein. Das MMA kann über 1.000, insbesondere über 10.000, besonders bevorzugt über 100.000 derartiger Spiegel umfassen. Es kann sich insbesondere um Spiegel zur Reflexion von EUV-Strahlung handeln.

Das optische Bauteil kann insbesondere Teil eines Facettenspiegels, insbesondere eines Feldfacettenspiegels, eines Strahlformungs- und Beleuchtungssystems der Lithographieanlage sein. Dabei ist das optische Bauteil insbesondere in einer evakuierbaren Kammer angeordnet. Beim Betrieb der Lithographieanlage kann diese evakuierbare Kammer insbesondere auf einen Druck von weniger als 50 Pa, insbesondere weniger als 20 Pa, insbesondere weniger als 10 Pa, insbesondere weniger als 5 Pa evakuiert werden. Hierbei gibt dieser Druck insbesondere den Partialdruck von Wasserstoff in der evakuierbaren Kammer an.

Die Strahlungsquelle ist insbesondere eine EUV-Strahlungsquelle mit einer emittierten Nutzstrahlung im Bereich zwischen 0,1 nm und 30 nm, bevorzugt zwischen 4 und 6 nm. Es kann sich dabei um eine Plasmaquelle, beispielsweise um eine GDPP-Quelle (Plasmaerzeugung durch Gasentladung, Gas Discharge Produced Plasma) oder um eine LPP-Quelle (Plasmaerzeugung durch Laser, Laser-Produced Plasma) handeln. Auch andere EUV-Strahlungsquellen, beispielsweise basierend auf einem Synchronton oder auf einem freien Elektronenlaser (Free Electron Laser, FEL), sind möglich.

Gemäß einer Ausführungsform ist $|f2 - n \cdot f1| > B$. Dabei bezeichnet $f1$ die Repetitionsfrequenz, $f2$ die Messsignalfrequenz, $n$ ganzzahlige Vielfache der Repetitionsfrequenz $f1$ und $B$ die Messbandbreite oder Bandbreite. Die Bedingung $|f2 - n \cdot f1| > B$ ist eine geeignete Sicherheitsgrenze dafür, dass die Mess-Einrichtung gegenüber durch EUV indizierte Strompulse desensibilisiert ist. Die Messbandbreite $B$ beträgt beispielsweise $f1/100$.

Gemäß einer weiteren Ausführungsform ist die Messsignalfrequenz $f2$ ungleich der Repetitionsfrequenz $f1$, ungleich den ganzzahligen Vielfachen der Repetitionsfrequenz $f1$ und kleiner als eine maximale Grenzfrequenz für die Messsignalfrequenz $f2$.

Die maximale Grenzfrequenz für die Messsignalfrequenz ist insbesondere applikationsabhängig und kann sich aus der Abtastfrequenz, mit der das optische Bauteil und die mit dem optischen Bauteil gekoppelte Aktuator- und/oder Sensor-Einrichtung abgetastet werden, ableiten. Beispielsweise ist die maximale Grenzfrequenz 10 MHz.

Gemäß einer weiteren Ausführungsform ist zwischen der Messsignalfrequenz $f2$ und der Repetitionsfrequenz $f1$ zumindest eine vorbestimmte Bandbreite $B$ vorgesehen. Ferner ist zwischen der Messsignalfrequenz $f2$ und dem jeweiligen ganzzahligen Vielfachen der Repetitionsfrequenz $f1$ jeweils zumindest eine vorbestimmte Bandbreite $B$ vorgesehen.

Durch den Einsatz der vorbestimmten Bandbreite $B$ zwischen der Messsignalfrequenz $f1$ und der Repetitionsfrequenz bzw. deren ganzzahligen Vielfachen kann ein gewisses Signal-Rausch-Verhältnis gewährleistet werden. Dadurch wird wiederum eine präzise Messung der Verlagerung bzw. der Position des optischen Bauteils gewährleistet. Die vorbestimmte Bandbreite $B$ sichert auch, dass die Position bzw. Verlagerung des optischen Bauteils dynamisch gemessen werden kann. Somit ist es auch möglich, die Position des optischen Bauteils auszuregeln.

Gemäß einer weiteren Ausführungsform beträgt die vorbestimmte Bandbreite zumindest 1 kHz, bevorzugt zumindest 10 kHz, besonders bevorzugt zumindest 20 kHz.

Wie oben ausgeführt, umfasst die Lithographieanlage eine Einstell-Einrichtung zum Einstellen der Messsignalfrequenz $f2$ in Abhängigkeit von der Repetitionsfrequenz $f1$.

Damit ist die Einstell-Einrichtung dazu eingerichtet, die Messsignalfrequenz $f2$ der Repetitionsfrequenz $f1$ der Strahlungsquelle nachzuführen. Dass die Repetitionsfrequenz $f1$ veränderlich ist, beinhaltet insbesondere ein aktives Ändern der Repetitionsfrequenz, beispielsweise durch eine Steuer-Einrichtung, aber auch ein passives Ändern der Repetitionsfrequenz, beispielsweise durch Alterung oder thermische Effekte.

Gemäß einer weiteren Ausführungsform ist die Messsignalfrequenz $f2$ eine Abtastfrequenz, wobei die Mess-Einrichtung dazu eingerichtet ist, das optische Bauteil und die mit dem optischen Bauteil verbundene Aktuator- und/oder Sensor-Einrichtung mit der Abtastfrequenz abzutasten. Die Aktuator- und/oder Sensor-Einrichtung kann insbesondere Elektroden oder Sensor-Elektroden umfassen.

Gemäß einer weiteren Ausführungsform ist die Mess-Einrichtung dazu eingerichtet, das optische Bauteil und die mit dem optischen Bauteil verbundene Aktuator- und/oder Sensor-Einrichtung mit einem Anregungssignal mit einer vorbestimmten Anregungsfrequenz $f3$ anzuregen und anschließend mit der Abtastfrequenz $f2$ abzutasten, wobei die Anregungsfrequenz $f3$ gleich der Abtastfrequenz $f2$ ist ($f3 = f2$).

Gemäß einer weiteren Ausführungsform umfasst die Lithographieanlage eine Steuer-Einrichtung zur gezielten Beaufschlagung des optischen Bauteils mit einem elektrischen Bias-Potential.

Durch Beaufschlagung des optischen Bauteils mit dem elektrischen Bias-Potenzial kann die Wechselwirkung zwischen dem optischen Bauteil und der zugeordneten Aktuator- und/oder Sensor-Einrichtung und deren Umgebung, insbesondere einem erzeugten Plasma, reduziert, insbesondere minimiert, bevorzugt eliminiert werden.

Mit anderen Worten, das elektrische Bias-Potenzial wird an das optische Bauteil angelegt, so dass sich das gesamte optische Bauteil, bevorzugt dessen optisch aktive Oberfläche, auf diesem Potenzial befindet. Hierdurch ist es möglich, den Strahlungs-, insbesondere den Plasma-induzierten Ladungstransport auf das optische Bauteil zu verringern, insbesondere zu minimieren, vorzugsweise zu eliminieren. Das Bias-Potenzial wird vorzugsweise derart gewählt, dass der über das optische Bauteil abfließende Strom reduziert, insbesondere minimiert, insbesondere eliminiert wird.

Das Bias-Potenzial kann fest vorgegeben werden. Es kann auch steuerbar, vorzugsweise regelbar sein.

Gemäß einer weiteren Ausführungsform weist die Steuer-Einrichtung eine Nachschlag-Tabelle zur Ermittlung des an das optische Bauteil anzulegenden Bias-Potentials auf.

Durch die Verwendung der Nachschlag-Tabelle (Lookup-Table, LUT) wird die Komplexität der Steuer-Einrichtung vereinfacht. Die Ermittlung des Bias-Potentials mit Hilfe der Nachschlag-Tabelle ermöglicht insbesondere eine einfache und kostengünstige Steuerung. Es ist auch möglich, die Steuer-Einrichtung mit mehreren Nachschlag-Tabellen für unterschiedliche Betriebsmodi der Lithographieanlage auszustatten. Beispielsweise kann jeweils eine eigene Nachschlag-Tabelle für unterschiedliche Strahlungsquellen vorgesehen sein. Die Nachschlag-Tabellen können jeweils unterschiedliche Werte für das anzulegende Bias-Potential für unterschiedliche Betriebsmodi der Strahlungsquelle aufweisen. Hierbei können insbesondere unterschiedliche Pulsfrequenzen, Pulsdauern und Intensitäten der Strahlungsquelle sowie unterschiedliche Zustände der evakuierbaren Kammer, insbesondere deren Druck, insbesondere die Partialdrücke für unterschiedliche Gase, sowie die Gaszusammensetzung in der Kammer vorgesehen sein.

Die Nachschlag-Tabelle oder Nachschlag-Tabellen können offline ermittelt werden. Sie können insbesondere auch experimentell ermittelt werden.

Gemäß einer weiteren Ausführungsform ist die Steuer-Einrichtung als Regel-Einrichtung mit mindestens einem Sensor ausgebildet.

Beispielsweise kann mittels des Sensors ein über das optische Bauteil abfließender elektrischer Strom erfasst werden. Mit Hilfe des Sensors ist es insbesondere möglich, die Ermittlung des Bias-Potentials dynamisch regelbar auszubilden. Hierdurch wird die Stabilität des optischen Bauteils weiter verbessert. Es ist insbesondere möglich, die Wirkung des Bias-Potenzials mit Hilfe des Sensors zu überwachen und den exakten Wert des zu beaufschlagenden Bias-Potenzials während des Betriebs der Lithographieanlage zu kalibrieren. Außerdem ist der Sensor vorzugsweise dazu eingerichtet, die Repetitionsfrequenz und deren Zeitlichkeit zu ermitteln.

Gemäß einer weiteren Ausführungsform ist die Lithographieanlage eine EUV-Lithographieanlage.

Gemäß einer weiteren Ausführungsform ist die Strahlungsquelle eine EUV-Strahlungsquelle, welche zur Erzeugung einer EUV-Strahlung mit der vorbestimmten Repetitionsfrequenz f1 eingerichtet ist.

Gemäß einer weiteren Ausführungsform umfasst die Mess-Einrichtung einen kapazitiven Sensor zur Messung der Position eines Kippwinkels des optischen Bauteils.

Gemäß einer weiteren Ausführungsform sind die Elektroden des kapazitiven Sensors kammförmig ausgebildet und verzahnt angeordnet.

Gemäß einer weiteren Ausführungsform ist das optische Bauteil ein Spiegel.

Gemäß einer weiteren Ausführungsform ist das optische Bauteil ein Einzelspiegel eines Feldfacettenspiegels eines Strahlformungs- und Beleuchtungssystems der Lithographieanlage.

Gemäß einer weiteren Ausführungsform ist das optische Bauteil ein Einzelspiegel eines Pupillenfacettenspiegels eines Strahlformungs- und Beleuchtungssystems der Lithographieanlage.

Die Einzelspiegel sind jeweils mittels einer Aktuator-Einrichtung mit mehreren elektromagnetisch, insbesondere elektrostatisch arbeitenden Aktuatoren verlagerbar, insbesondere positionierbar. Die Aktuatoren lassen sich in einem Batch-Prozess als mikroelektromechanisches System (Micro-Electro-Mechanical System, MEMS) herstellen. Für Details wird hierzu auf das Dokument WO 2010/049 076 A1 verwiesen, dessen Inhalt in Bezug genommen wird. Zur Ausbildung des Feldfacettenspiegels sowie zur Ausbildung des Pupillenfacettenspiegels wird auf die DE 10 2013 209 442 A1 verwiesen, deren Inhalt in Bezug genommen wird.

Außerdem wird ein Verfahren zum Betreiben einer Lithographieanlage vorgeschlagen. Die Lithographieanlage umfasst eine Strahlungsquelle zur Erzeugung einer Strahlung mit einer bestimmten Repetitionsfrequenz f1, ein optisches Bauteil zur Führung der Strahlung in der Lithographieanlage, eine Aktuator-Einrichtung zur Verlagerung des optischen Bauteils und eine Mess-Einrichtung zum Ermitteln einer Position des optischen Bauteils. Dabei wird die Position des optischen Bauteils durch die Mess-Einrichtung mittels eines Messsignals mit einer bestimmten Messsignalfrequenz f2 ermittelt und die Messsignalfrequenz wird in Abhängigkeit von der Repetitionsfrequenz mittels einer Einstell-Einrichtung derart eingestellt, dass die Messsignalfrequenz f2 ungleich der Repetitionsfrequenz f1 und ungleich ganzzahligen Vielfachen der Repetitionsfrequenz f1 ist.

Insbesondere wird die Messsignalfrequenz f2 derart eingestellt, insbesondere gesteuert oder geregelt, dass sie ungleich der Repetitionsfrequenz f1 und ungleich der ganzzahligen Vielfachen der Repetitionsfrequenz f1 ist.

Die für die vorgeschlagene Vorrichtung beschriebenen Ausführungsformen und Merkmale gelten für das vorgeschlagene Verfahren entsprechend.

Weiterhin wird ein Computerprogrammprodukt vorgeschlagen, welches auf einer programmgesteuerten Einrichtung das Betreiben einer Lithographieanlage des wie oben erläuterten Verfahrens derart veranlasst, dass die Messsignalfrequenz f2 ungleich der Repetitionsfrequenz f1 und ungleich ganzzahligen Vielfachen der Repetitionsfrequenz f1 ist.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Gemäß einem weiteren Aspekt wird eine Lithographieanlage vorgeschlagen, welche eine Strahlungsquelle zur Erzeugung einer Strahlung mit einer bestimmten Repetitionsfrequenz, ein optisches Bauteil zur Führung der Strahlung in der Lithographieanlage, eine Aktuator-Einrichtung zur Verlagerung des optischen Bauteils, eine Mess-Einrichtung zum Ermitteln einer Position des optischen Bauteils mittels eines Messsignals und eine Synchronisations-Einrichtung aufweist. Die Synchronisations-Einrichtung ist dazu eingerichtet, das Messsignal und die von der Strahlungsquelle erzeugte Strahlung zeitlich zu synchronisieren.

Dabei bedeutet Synchronisation von Messsignal und Strahlung insbesondere, dass die Synchronisations-Einrichtung eine aktuelle Information darüber hat, wie der Status der Strahlungsquelle aktuell ist, das heißt insbesondere, ob die Strahlungsquelle gerade die Strahlung aussendet oder nicht und/oder wie die Lage der Strahlung ist. Abhängig von dieser Information kann die Synchronisations-Einrichtung zumindest eine Aktion ableiten und ausführen. Eine solche Aktion kann eine Anpassung der Messsignalfrequenz des Messsignals, eine Anpassung der Phase des Messsignals und/oder eine Anpassung einer Amplitude des Messsignals umfassen.

Gemäß einer Weiterbildung ist die Synchronisations-Einrichtung dazu eingerichtet, eine aktuelle Information über die von der Strahlungsquelle erzeugte Strahlung zu empfangen und das Messsignal in Abhängigkeit der empfangenen aktuellen Information anzupassen.

Gemäß einer weiteren Weiterbildung ist die Synchronisations-Einrichtung dazu eingerichtet, eine Amplitude des Messsignals in Abhängigkeit der empfangenen aktuellen Information anzupassen.

Gemäß einer weiteren Weiterbildung ist die Synchronisations-Einrichtung dazu eingerichtet, eine Phase des Messsignals in Abhängigkeit der empfangenen aktuellen Information anzupassen.

Gemäß einer weiteren Weiterbildung ist die Synchronisations-Einrichtung dazu eingerichtet, eine Messsignalfrequenz des Messsignals in Abhängigkeit der empfangenen aktuellen Information anzupassen.

Gemäß einer weiteren Weiterbildung ist die Synchronisations-Einrichtung dazu eingerichtet, die Messsignalfrequenz derart einzustellen, dass sie ungleich der Repetitionsfrequenz und ungleich ganzzahligen Vielfachen der Repetitionsfrequenz ist.

Gemäß einer weiteren Weiterbildung ist die Synchronisations-Einrichtung dazu eingerichtet, das Messsignal mittels einer Manipulation der Amplitude, der Frequenz oder der Phase des Anregungssignals zu verändern.

Gemäß einer weiteren Weiterbildung ist die Synchronisations-Einrichtung dazu eingerichtet, das Messsignal mittels einer Überlagerung des Anregungssignals mit mindestens einem weiteren Signal zu manipulieren.

Gemäß einer weiteren Weiterbildung ist die Synchronisations-Einrichtung dazu eingerichtet, eine aktuelle Information über die von der Strahlungsquelle erzeugte Strahlung zu empfangen und eine Auswertung des Messsignals in Abhängigkeit von der empfangenen aktuellen Information anzupassen.

Gemäß einer weiteren Weiterbildung ist die Synchronisations-Einrichtung dazu eingerichtet, in Abhängigkeit der empfangenen aktuellen Information bestimmte Bereiche des Messsignals bei der Auswertung des Messsignals zu maskieren.

Gemäß einer weiteren Weiterbildung umfasst die Lithographieanlage eine Übertragungs-Einrichtung, welche dazu eingerichtet ist, die aktuelle Information über die von der Strahlungsquelle erzeugte Strahlung, insbesondere eine Frequenz, eine Phase und/oder eine Amplitude der Strahlung, von der Strahlungsquelle an die Synchronisations-Einrichtung zu übertragen.

Gemäß einer weiteren Weiterbildung umfasst die Lithographieanlage eine Extraktionseinheit, welche dazu eingerichtet ist, die Information über die von der Strahlungsquelle erzeugte Strahlung aus einem Störsignalanteil des Messsignals zu extrahieren.

Gemäß einer weiteren Weiterbildung umfasst die Aktuator-Einrichtung eine Aufhängung zur Lagerung des optischen Bauteils über einer Basisplatte, wobei die Aufhängung derart ausgebildet ist, dass der elektrische Widerstand eines Pfads zwischen der mit dem optischen Bauteil verbundenen Elektrode des kapazitiven Sensors, dem optischen Bauteil, der Aufhängung und der elektrischen Ankopplung an die Mess-Einrichtung kleiner als 1 kΩ, bevorzugt kleiner als 100 Ω, besonders bevorzugt kleiner als 10 Ω, ist.

Durch den geringen elektrischen Widerstand dieses Pfads ist die Strom-Spannungs-Wandlung auf dem optischen Bauteil reduziert. Dadurch sind Störungen, hervorgerufen durch die Photonen der EUV-Strahlungsquelle, in allen Frequenzbereichen minimiert.

Gemäß einer weiteren Weiterbildung ist die Aufhängung aus einem dotierten Halbleitermaterial, beispielsweise aus einem dotierten Polysilizium, hergestellt.

Das Polysilizium der Aufhängung ist insbesondere derart dotiert, dass der elektrische Widerstand des oben näher beschriebenen Pfads minimiert ist.

Gemäß einer weiteren Weiterbildung ist die Aufhängung derart dotiert, dass der elektrische Widerstand des Pfads zwischen der mit dem optischen Bauteil verbundenen Elektrode des kapazitiven Sensors, dem optischen Bauteil, der Aufhängung und der elektrischen Ankopplung an die Mess-Einrichtung kleiner als 1 kΩ, bevorzugt kleiner als 100 Ω, besonders bevorzugt kleiner als 10 Ω ist.

Gemäß einer weiteren Weiterbildung ist die Aufhängung derart in ihrer Geometrie ausgebildet, dass der elektrische Widerstand des Pfads zwischen der mit dem optischen Bauteil verbundenen Elektrode des kapazitiven Sensors, dem optischen Bauteil, der Aufhängung und der elektrischen Ankopplung an die Mess-Einrichtung kleiner als 1 kΩ, bevorzugt kleiner als 100 Ω, besonders bevorzugt kleiner als 10 Ω ist.

Insbesondere sind die Geometrie der Aufhängung und die Dotierung der Aufhängung derart kombiniert ausgebildet, dass die Aufhängung zum einen ausreichend stabil und zum anderen einen möglichst geringen elektrischen Widerstand aufweist.

Gemäß einer weiteren Weiterbildung ist die Mess-Einrichtung dazu eingerichtet, das optische Bauteil und die mit dem optischen Bauteil verbundenen Elektroden mit einem Anregungssignal mit einer vorbestimmten Anregungsfrequenz und einem vorbestimmten Spannungswert größer 3,3 V und kleiner gleich 20 V anzuregen und anschließend mit der Abtastfrequenz abzutasten, wobei die Anregungsfrequenz gleich der Abtastfrequenz ist.

Durch die Ausbildung des Anregungssignals mit einem erhöhten Spannungswert wird der Einfluss von EUV-bedingten Störungen für das Messsignal verringert.

Gemäß einer weiteren Weiterbildung liegt der vorbestimmte Spannungswert des Anregungssignals zwischen 6,6 V und 20 V, bevorzugt zwischen 6,6 V und 15 V.

Gemäß einer weiteren Weiterbildung weist das optische Bauteil eine erste Schicht und eine von der ersten Schicht mittels eines Dielektrikums getrennte zweite Schicht auf, wobei die erste Schicht eine Spiegelschicht ist und die zweite Schicht zur elektrischen Kopplung mit dem kapazitiven Sensor eingerichtet ist.

Durch die Ausbildung des optischen Bauteils mit den beiden getrennten Schichten ist es möglich, beide getrennten Schichten an ein gemeinsames Bezugspotential, beispielsweise an Masse, zu legen. Hierdurch ist eine Verringerung des Einflusses von EUV-bedingten Störungen möglich.

Gemäß einer weiteren Weiterbildung sind die erste Schicht und die zweite Schicht jeweils mit einem gemeinsamen Bezugspotential elektrisch gekoppelt.

Gemäß einer weiteren Weiterbildung ist das gemeinsame Bezugspotential Masse.

Gemäß einer weiteren Weiterbildung bilden ein elektrischer Widerstand eines Pfads zwischen dem Dielektrikum und dem Bezugspotential über die zweite Schicht und eine durch die erste Schicht, das Dielektrikum und die zweite Schicht gebildete Kapazität ein Hochpassfilter aus.

Das Hochpassfilter ist insbesondere dazu geeignet, niederfrequente EUVbedingte Störungen zu filtern.

Die jeweilige Einheit, zum Beispiel Auswerteeinheit oder Extraktionseinheit, kann hardwaretechnisch und/oder auch softwaretechnisch implementiert sein. Bei einer hardwaretechnischen Implementierung kann die jeweilige Einheit als Vorrichtung oder als Teil einer Vorrichtung, zum Beispiel als Computer oder als Mikroprozessor oder als Steuerrechner eines Fahrzeuges ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Gemäß einem weiteren Aspekt wird ein Verfahren zum Betreiben einer Lithographieanlage vorgeschlagen, welche eine Strahlungsquelle zur Erzeugung einer Strahlung mit einer bestimmten Repetitionsfrequenz, ein optisches Bauteil zur Führung der Strahlung in der Lithographieanlage, eine Aktuator-Einrichtung zur Verlagerung des optischen Bauteils und eine Mess-Einrichtung zum Ermitteln einer Position des optischen Bauteils mittels eines Messsignals aufweist. Dabei werden das Messsignal und die von der Strahlungsquelle erzeugte Strahlung zeitlich synchronisiert.

Gemäß einem weiteren Aspekt wird eine Lithographieanlage vorgeschlagen, welche eine Strahlungsquelle zur Erzeugung einer Strahlung mit einer bestimmten Repetitionsfrequenz, ein optisches Bauteil zur Führung der Strahlung in der Lithographieanlage, eine Aktuator-Einrichtung zur Verlagerung des optischen Bauteils und eine Mess-Einrichtung zum Ermitteln einer Position des optischen Bauteils mittels eines Messsignals mit einer bestimmten Messsignalfrequenz aufweist. Die Mess-Einrichtung weist einen kapazitiven Sensor zur Messung der Position eines Kippwinkels des optischen Bauteils auf, wobei die Elektroden des kapazitiven Sensors kammförmig ausgebildet und verzahnt angeordnet sind. Dabei ist die Aufhängung derart ausgebildet, dass der elektrische Widerstand eines Pfads zwischen der mit dem optischen Bauteil verbundenen Elektrode des kapazitiven Sensors, dem optischen Bauteil, der Aufhängung und der elektrischen Ankopplung an die Mess-Einrichtung kleiner als 1 kΩ, bevorzugt kleiner als 100 Ω, besonders bevorzugt kleiner als 10 Ω ist.

Gemäß einer Weiterbildung ist die Aufhängung zur Lagerung des optischen Bauteils aus einem dotierten Halbleitermaterial, beispielsweise aus einem dotierten Polysilizium, hergestellt.

Gemäß einer weiteren Weiterbildung ist die Aufhängung derart in ihrer Geometrie ausgebildet, dass der elektrische Widerstand eines Pfads zwischen der mit dem optischen Bauteil verbundenen Elektrode des kapazitiven Sensors, dem optischen Bauteil, der Aufhängung und der elektrischen Ankopplung an die Mess-Einrichtung kleiner als 1 kΩ, bevorzugt kleiner als 100 Ω, besonders bevorzugt kleiner als 10 Ω ist.

Gemäß einem weiteren Aspekt wird eine Lithographieanlage vorgeschlagen, welche eine Strahlungsquelle zur Erzeugung einer Strahlung mit einer bestimmten Repetitionsfrequenz, ein optisches Bauteil zur Führung der Strahlung in der Lithographieanlage, eine Aktuator-Einrichtung zur Verlagerung des optischen Bauteils und eine Mess-Einrichtung zum Ermitteln einer Position des optischen Bauteils mittels eines Messsignals mit einer bestimmten Messsignalfrequenz aufweist. Die Mess-Einrichtung weist einen kapazitiven Sensor zur Messung der Position eines Kippwinkels des optischen Bauteils auf, wobei die Elektroden des kapazitiven Sensors kammförmig ausgebildet und verzahnt angeordnet sind. Dabei ist die Mess-Einrichtung dazu eingerichtet, das optische Bauteil und die mit dem optischen Bauteil verbundenen Elektroden mit einem Anregungssignal mit einer vorbestimmten Anregungsfrequenz und einem vorbestimmten Spannungswert zwischen größer 3,3 V und kleiner gleich anzuregen und anschließend mit der Abtastfrequenz abzutasten, wobei die Anregungsfrequenz gleich der Abtastfrequenz ist.

Gemäß einer weiteren Weiterbildung liegt der vorbestimmte Spannungswert des Anregungssignals zwischen 6,6 V und 20 V, bevorzugt zwischen 6,6 V und 15 V.

Gemäß einem weiteren Aspekt wird eine Lithographieanlage vorgeschlagen, welche eine Strahlungsquelle zur Erzeugung einer Strahlung mit einer bestimmten Repetitionsfrequenz, ein optisches Bauteil zur Führung der Strahlung in der Lithographieanlage, eine Aktuator-Einrichtung zur Verlagerung des optischen Bauteils und eine Mess-Einrichtung zum Ermitteln einer Position des optischen Bauteils mittels eines Messsignals mit einer bestimmten Messsignalfrequenz aufweist. Die Mess-Einrichtung weist einen kapazitiven Sensor zur Messung der Position eines Kippwinkels des optischen Bauteils auf. Dabei weist das optische Bauteil eine erste Schicht und eine von der ersten Schicht mittels eines Dielektrikums getrennte zweite Schicht auf, wobei die erste Schicht eine Spiegelschicht ist und die zweite Schicht zur elektrischen Kopplung mit dem kapazitiven Sensor eingerichtet ist.

Gemäß einer Weiterbildung sind die erste Schicht und die zweite Schicht jeweils mit einem gemeinsamen Bezugspotential elektrisch gekoppelt. Das gemeinsame Bezugspotential ist beispielsweise Masse.

Gemäß einer weiteren Weiterbildung bilden ein elektrischer Widerstand eines Pfads zwischen dem Dielektrikum und dem Bezugspotential über die zweite Schicht und eine durch die erste Schicht, das Dielektrikum und die zweite Schicht gebildete Kapazität ein Hochpassfilter aus.

Gemäß einem weiteren Aspekt wird eine Lithographieanlage vorgeschlagen, welche eine kontinuierlich eingeschaltete Strahlungsquelle zur Erzeugung einer Strahlung mit einer bestimmten Repetitionsfrequenz, ein optisches Bauteil zur Führung der Strahlung in der Lithographieanlage, eine Aktuator-Einrichtung zur Verlagerung des optischen Bauteils, eine Mess-Einrichtung zum Ermitteln einer Position des optischen Bauteils mittels eines Messsignals mit einer bestimmten Messsignalfrequenz und eine dem optischen Bauteil im optischen Pfad der Lithographieanlage nachgeordnete Vorrichtung zum Öffnen und Unterbrechen des optischen Pfads aufweist.

Gemäß einer Weiterbildung weist die Lithographieanlage eine Shutter-Einrichtung auf, welche die Vorrichtung zum Öffnen und Unterbrechen des optischen Pfads umfasst.

Gemäß einem weiteren Aspekt wird eine Lithographieanlage vorgeschlagen, welche eine zu bestimmten Einschaltzeiten periodisch eingeschaltete Strahlungsquelle zur Erzeugung einer Strahlung mit einer bestimmten Repetitionsfrequenz, ein optisches Bauteil zur Führung der Strahlung in der Lithographieanlage, eine Aktuator-Einrichtung zur Verlagerung des optischen Bauteils, eine Mess-Einrichtung zum Ermitteln einer Position des optischen Bauteils mittels eines Messsignals mit einer bestimmten Messsignalfrequenz und eine mit dem optischen Bauteil gekoppelte Spannungsquelle zum Emulieren von durch die von der Strahlung der Strahlungsquelle zu den bestimmten Einschaltzeiten an dem optischen Bauteil erzeugten Störpulsen außerhalb der bestimmten Einschaltzeiten aufweist.

Gemäß einer Weiterbildung ist die Spannungsquelle dazu eingerichtet, die Störpulse außerhalb der bestimmten Einschaltzeiten mit der bestimmten Repetitionsfrequenz der Strahlungsquelle zu emulieren.

Des Weiteren wird ein Computerprogrammprodukt vorgeschlagen, welches auf einer programmgesteuerten Einrichtung das Betreiben einer Lithographieanlage des wie oben erläuterten Verfahrens derart veranlasst, dass das Messsignal und die von der Strahlungsquelle erzeugte Strahlung zeitlich synchronisiert werden.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.

Fig. 1 zeigt eine schematische Ansicht einer EUV-Lithographieanlage;

Fig. 2 zeigt eine schematische Ansicht einer ersten Ausführungsform eines Aspekts der EUV-Lithographieanlage;

Fig. 3 zeigt ein Diagramm zur Illustrierung eines Beispiels für die EUV-Strahlung und das Messsignal;

Fig. 4 zeigt ein Diagramm zur Illustrierung des Signal-Rausch-Verhältnisses für das Messsignal bei einer beispielhaften Implementierung von Strahlungsquelle und Mess-Einrichtung der EUV-Lithographieanlage;

Fig. 5 zeigt eine schematische Ansicht einer zweiten Ausführungsform eines Aspekts der EUV-Lithographieanlage;

Fig. 6 zeigt eine schematische Ansicht einer dritten Ausführungsform eines Aspekts der EUV-Lithographieanlage;

Fig. 7 zeigt eine erste Ausführungsform eines Verfahrens zum Betreiben einer EUV-Lithographieanlage;

Fig. 8 zeigt eine schematische Ansicht einer vierten Ausführungsform eines Aspekts der EUV-Lithographieanlage;

Fig. 9 zeigt eine schematische Ansicht einer fünften Ausführungsform eines Aspekts einer EUV-Lithographieanlage;

Fig. 10 zeigt eine schematische Ansicht einer sechsten Ausführungsform eines Aspekts einer EUV-Lithographieanlage;

Fig. 11 zeigt eine zweite Ausführungsform eines Verfahrens zum Betreiben einer EUV-Lithographieanlage;

Fig. 12 zeigt eine schematische Ansicht einer siebten Ausführungsform eines Aspekts der EUV-Lithographieanlage;

Fig. 13 zeigt ein vereinfachtes elektrisches Ersatzschaltbild für die Anordnung der Fig. 12;

Fig. 14 zeigt ein Diagramm zur Illustrierung des Leistungsdichtespektrums einer EUV-bedingten Störung des Messsignals bei einem Widerstand $R_{MP}$ von 10 Ω;

Fig. 15 zeigt ein vereinfachtes elektrisches Ersatzschaltbild für eine achte Ausführungsform eines Aspekts der EUV-Lithographieanlage;

Fig. 16 zeigt eine schematische Ansicht einer neunten Ausführungsform eines Aspekts der EUV-Lithographieanlage; und

Fig. 17 zeigt ein vereinfachtes elektrisches Ersatzschaltbild für eine zehnte Ausführungsform eines Aspekts der EUV-Lithographieanlage;

In den Figuren sind gleiche oder funktionsgleiche Elemente mit denselben Bezugszeichen versehen worden, sofern nichts anderes angegeben ist. Ferner sollte beachtet werden, dass die Darstellungen in den Figuren nicht notwendigerweise maßstabsgerecht sind.

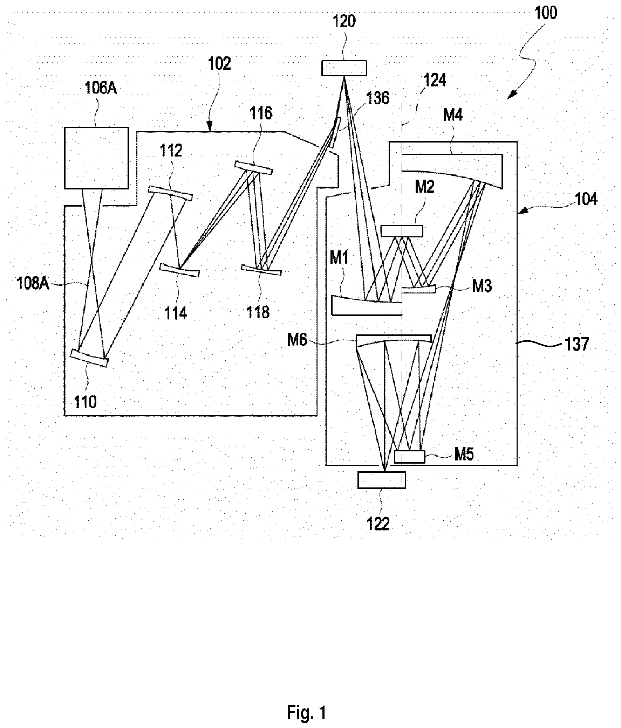

Fig. 1 zeigt eine schematische Ansicht einer EUV-Lithographieanlage 100, welche ein Strahlformungs- und Beleuchtungssystem 102 und ein Projektionssystem 104 umfasst. Dabei steht EUV für "extremes Ultraviolett" (Engl.: extreme ultraviolett, EUV) und bezeichnet eine Wellenlänge des Arbeitslichts zwischen 0,1 und 30 nm. Das Strahlformungs- und Beleuchtungssystem 102 und das Projektionssystem 104 sind jeweils in einem Vakuum-Gehäuse vorgesehen, wobei jedes Vakuum-Gehäuse mit Hilfe einer nicht näher dargestellten Evakuierungsvorrichtung evakuiert wird. Die Vakuum-Gehäuse sind von einem nicht näher dargestellten Maschinenraum umgeben. In diesem Maschinenraum können auch elektrische Steuerungen und dergleichen vorgesehen sein.

Die EUV-Lithographieanlage 100 weist eine EUV-Strahlungsquelle oder EUV-Lichtquelle 106A auf. Als EUV-Lichtquelle 106A kann beispielsweise eine Plasmaquelle vorgesehen sein, welche Strahlung 108A im EUV-Bereich (extrem ultravioletten Bereich), also z.B. im Wellenlängenbereich von 5 nm bis 30 nm aussenden. Im Strahlformungs- und Beleuchtungssystem 102 wird die EUV-Strahlung 108A gebündelt und die gewünschte Betriebswellenlänge aus der EUV-Strahlung 108A herausgefiltert. Die von der EUV-Lichtquelle 106A erzeugte EUV-Strahlung 108A weist eine relativ niedrige Transmissivität durch Luft auf, weshalb die Strahlführungsräume im Strahlformungs- und Beleuchtungssystem 102 und im Projektionssystem 104 evakuiert sind.

Das in Fig. 1 dargestellte Strahlformungs- und Beleuchtungssystem 102 weist fünf Spiegel 110, 112, 114, 116, 118 auf. Nach dem Durchgang durch das Strahlformungs- und Beleuchtungssystem 102 wird die EUV-Strahlung 108A auf die Photomaske (Engl.: reticle) 120 geleitet. Die Photomaske 120 ist ebenfalls als reflektives optisches Element ausgebildet und kann außerhalb der Systeme 102, 104 angeordnet sein. Weiter kann die EUV-Strahlung 108A mittels eines Spiegels 136 auf die Photomaske 120 gelenkt werden. Die Photomaske 120 weist eine Struktur auf, welche mittels des Projektionssystems 104 verkleinert auf einen Wafer 122 oder dergleichen abgebildet wird.

Das Projektionssystem 104 weist sechs Spiegel M1 - M6 zur Abbildung der Photomaske 120 auf den Wafer 122 auf. Dabei können einzelne Spiegel M1 - M6 des Projektionssystems 104 symmetrisch zur optischen Achse 124 des Projektionssystems 104 angeordnet sein. Es sollte beachtet werden, dass die Anzahl der Spiegel der EUV-Lithographieanlage 100 nicht auf die dargestellte Anzahl beschränkt ist. Es können auch mehr oder weniger Spiegel vorgesehen sein. Des Weiteren sind die Spiegel M1 - M6 i.d.R. an ihrer Vorderseite zur Strahlformung gekrümmt.

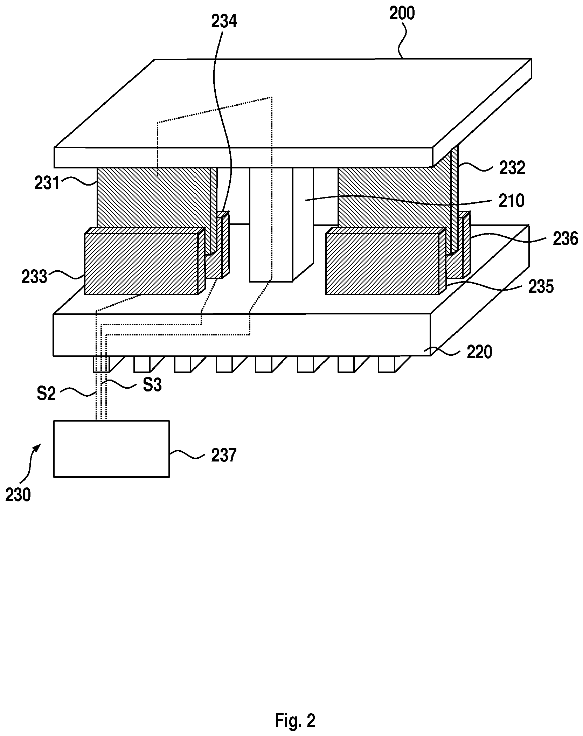

Fig. 2 zeigt eine schematische Ansicht einer ersten Ausführungsform eines Aspekts der EUV-Lithographieanlage 100.

Dabei zeigt die Fig. 2 einen Spiegel 200 als optisches Bauteil und einem dem Spiegel 200 zugeordnete Mess-Einrichtung 230. Der Spiegel 200 kann als Einzelspiegel bzw. als MEMS-Spiegel ausgebildet sein und beispielsweise Teil eines der Spiegel 110, 112, 114, 116, 118 des Strahlformungs- und Beleuchtungssystems 102 der EUV-Lithographieanlage 100 der Fig. 1 sein. Der Einzelspiegel 200 der Fig. 2 kann auch Teil eines der weiteren Spiegel M1-M6 der EUV-Lithographieanlage 100 der Fig. 1 sein.

Ferner illustriert die Fig. 2, dass der Spiegel 200 über eine Aufhängung 210 mit einer Basisplatte 220 verbunden ist. Die Aufhängung 210 ist Teil einer nicht näher dargestellten Aktuator-Einrichtung 210 zur Verlagerung des Spiegels 200. Details für ein Beispiel einer solchen Aktuator-Einrichtung 210 ergeben sich aus dem Dokument DE 10 2013 442 A1.

Die Mess-Einrichtung 230 ist zum Ermitteln einer Position des Spiegels 200 mittels eines Messsignals S2 mit einer bestimmten Messsignalfrequenz f2 eingerichtet. Die Messsignalfrequenz f2 ist beispielsweise eine Abtastfrequenz. Dabei ist die Mess-Einrichtung 230 vorzugsweise eingerichtet, den Spiegel 200 und die mit dem Spiegel 200 verbundene Sensor-Elektroden 231 - 236 mit einem Anregungssignal S3 mit einer vorbestimmten Anregungsfrequenz f3 anzuregen und anschließend mit der Abtastfrequenz f2 abzutasten. Die Anregungsfrequenz f3 ist insbesondere gleich der Abtastfrequenz f2. Alternativ kann die Abtastfrequenz f2 auch höher als die Anregungsfrequenz f3 sein. Die Messsignalfrequenz f2 ist ungleich der Repetitionsfrequenz f1 und ungleich ganzzahligen Vielfachen der Repetitionsfrequenz f1. Damit ist die Messsignalfrequenz f2 ungleich der Repetitionsfrequenz f1 der EUV-Strahlungsquelle 106A und der Frequenzen deren Harmonischen. In Fig. 2 ist die Leitung S4 mit einem Bezugspotential oder Referenzpotential, beispielsweise mit Masse, verbunden. Hierzu weist die Mess-Einrichtung 230 eine Anzahl von Elektroden 231 - 236 auf, die kammförmig ausgebildet und verzahnt angeordnet sind. Damit bildet die Mess-Einrichtung 230 einen kapazitiven Sensor zur Ermittlung der Position eines Kippwinkels des Spiegels 200 aus. Die Elektroden oder Sensor-Elektroden 231 - 236 sind mittels elektrischer Leitungen mit einer Auswerteeinheit 237 verbunden. Die Auswerteeinheit 237 ist dazu eingerichtet, den Spiegel 200 und die mit dem Spiegel 200 verbundenen Sensor-Elektroden 231 - 236 mit dem Anregungssignal S3 anzuregen und das sich ergebene Messsignal S2 zu empfangen und auszuwerten. Die Auswerteeinheit 237 kann als Softwareprodukt implementiert sein und Teil einer zentralen Steuervorrichtung der Lithographieanlage 100 sein.

Bei der Wahl der Messsignalfrequenz f2 gilt insbesondere folgende Bedingung:

$$| f2 - n{\cdot}f1 | > B$$

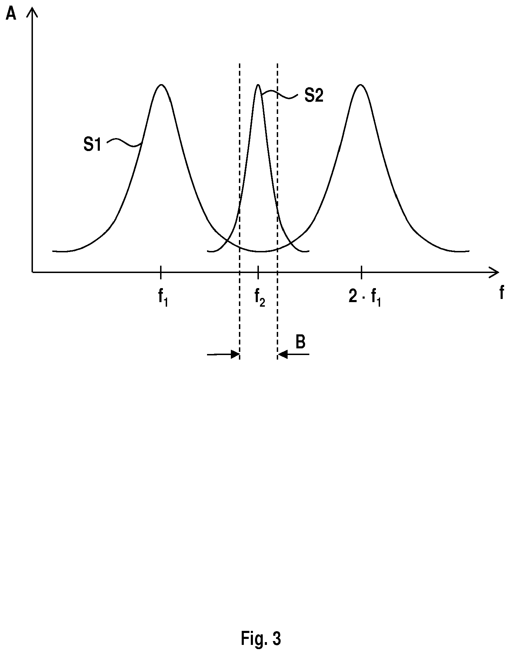

Insbesondere ist zwischen der Messsignalfrequenz f2 und der Repetitionsfrequenz f1 sowie zwischen der Messsignalfrequenz f2 und einem jeweiligen ganzzahligen Vielfachen der Repetitionsfrequenz f1 jeweils eine bestimmte Bandbreite B vorgesehen. Hierzu zeigt die Fig. 3 ein Diagramm zur Illustrierung eines Beispiels für die EUV-Strahlung S1 und das Messsignal S2. Die Kurve für die EUV-Strahlung S1 zeigt beispielhaft zwei Maxima bei der Repetitionsfrequenz f1 und bei 2 · f1 (n=2.) Die Messsignalfrequenz f2 ist gemäß Fig. 3 derart gewählt, dass sie exakt zwischen den Frequenzen f1 und 2 · f1 liegt. Die in Fig. 3 ferner abgebildete Bandbreite B um die Messsignalfrequenz f2 ist beispielsweise 5 kHz, 10 kHz oder 20 kHz.

Des Weiteren ist die Messsignalfrequenz f2 nicht nur ungleich der Repetitionsfrequenz f1 und ungleich den ganzzahligen Vielfachen der Repetitionsfrequenz f1, beispielsweise 2 · f1, sondern auch kleiner als eine maximale Grenzfrequenz für die Messsignalfrequenz f2. Die maximale Grenzfrequenz für die Messsignalfrequenz f2 ist applikationsabhängig und beispielsweise 10 MHz.

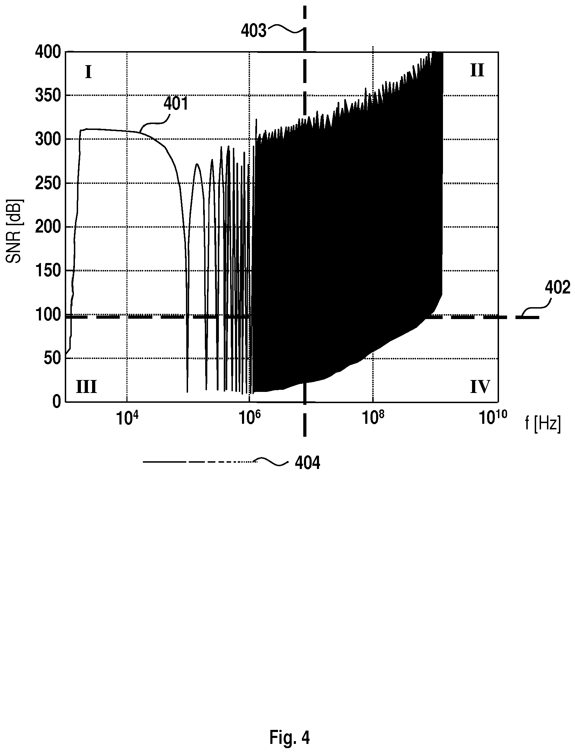

Hierzu zeigt die Fig. 4 ein Diagramm zur Illustrierung des Signal-Rausch-Verhältnisses (Signal-to-Noise-Ratio, SNR) für das Messsignal S2 bei einer beispielhaften Implementierung von Strahlungsquelle 106A und Mess-Einrichtung 230. Dabei zeigt die x-Achse der Fig. 4 die Frequenz in Hz im logarithmischen Maßstab, wohingegen die y-Achse das Signal-Rausch-Verhältnis SNR in dB zeigt.

Die Kurve 401 in Fig. 4 zeigt das SNR des Messsignals S2, die Kurve 402 zeigt eine applikationsspezifische Untergrenze für das SNR, die Kurve 403 zeigt eine maximale Grenzfrequenz des Anregungssignals S3. Die Untergrenze 402 des SNR ist applikationsspezifisch und beträgt beispielsweise 98 dB. Die Linien 402 und 403 teilen das Diagramm der Fig. 4 in vier Quadranten I, II, III, und IV.

Hinsichtlich der Wahl der Messsignalfrequenz f2 zeigt die Linie 404 mögliche Werte für die Messsignalfrequenz f2. Mit anderen Worten illustriert die Linie 404 solche Werte für die Messsignalfrequenz f2, bei denen sich für das SNR 401 nur solche Werte ergeben, die in dem ersten Quadranten I der Fig. 4 liegen.

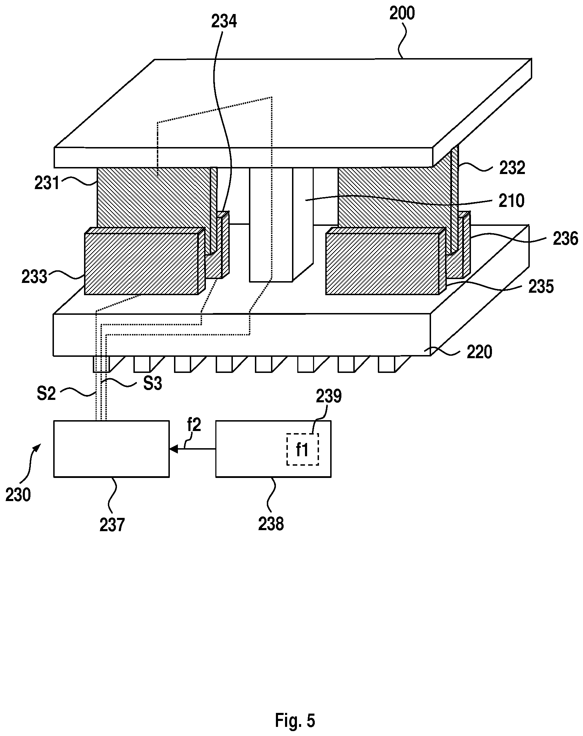

Fig. 5 zeigt eine schematische Ansicht einer zweiten Ausführungsform eines Aspekts einer EUV-Lithographieanlage 100 der Fig. 1.

Die zweite Ausführungsform der Fig. 5 basiert auf der ersten Ausführungsform der Fig. 2 und weist sämtliche Merkmale der ersten Ausführungsform der Fig. 2 auf. Darüber hinaus zeigt die Fig. 5, dass eine Einstell-Einrichtung 238 vorgesehen ist. Die Einstell-Einrichtung 238 ist dazu eingerichtet, die Messsignalfrequenz f2 in Abhängigkeit von der Repetitionsfrequenz f1 einzustellen.

Für den Fall, dass die Repetitionsfrequenz f1 der EUV-Strahlungsquelle 106A fest ist, kann eine Speicher-Einrichtung 239 vorgesehen sein, welche diesen Wert der Repetitionsfrequenz f1 speichert und der Einstell-Einrichtung 238 bereitstellt. Diese Speicher-Einrichtung 239 kann auch Teil der Einstell-Einrichtung 238 sein.

Für den Fall, dass die Repetitionsfrequenz f1 veränderlich ist, kann der aktuelle Wert der Repetitionsfrequenz f1 der Einstell-Einrichtung 238 beispielsweise durch eine Ermittlungs-Einrichtung (nicht gezeigt) bereitgestellt werden, welche dazu eingerichtet ist, den aktuellen Wert der Repetitionsfrequenz f1 zu messen.

Für den Fall, dass die Repetitionsfrequenz f1 veränderlich ist, kann die Einstell-Einrichtung 238 dazu eingerichtet werden, die Messsignalfrequenz f2 in Abhängigkeit der sich veränderlichen Repetitionsfrequenz f1 einzustellen. Mit anderen Worten kann die Einstell-Einrichtung 238 dazu eingerichtet sein, die Messsignalfrequenz f2 der Repetitionsfrequenz f1 nachzuführen.

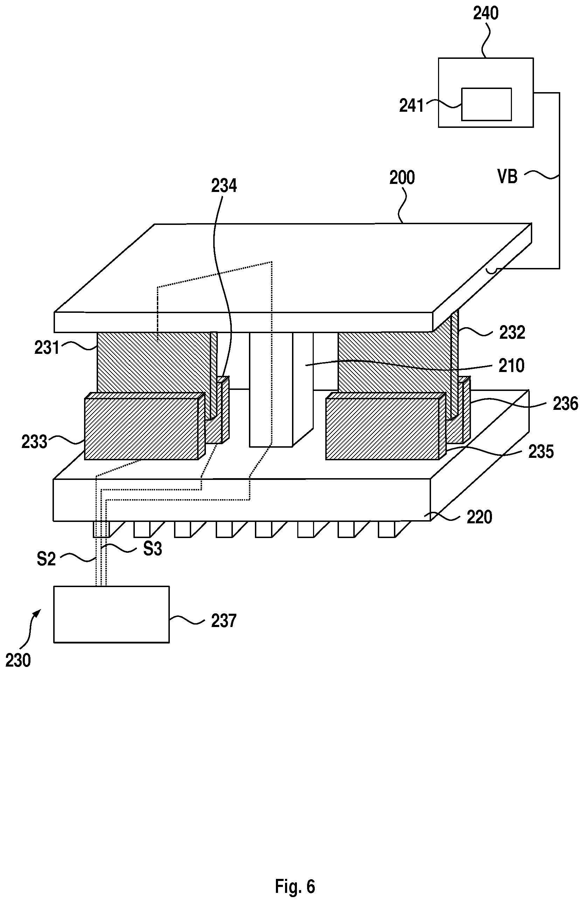

In Fig. 6 ist eine schematische Ansicht einer dritten Ausführungsform eines Aspekts der EUV-Lithographieanlage 100 dargestellt.

Die dritte Ausführungsform der Fig. 6 basiert auf der ersten Ausführungsform der Fig. 2 und umfasst sämtliche Merkmale der ersten Ausführungsform der Fig. 2. Darüber hinaus ist in der dritten Ausführungsform der Fig. 6 eine Steuer-Einrichtung 240 vorgesehen. Die Steuer-Einrichtung 240 ist dazu eingerichtet, den Spiegel 200 mit einem elektrischen Bias-Potential VB zu beaufschlagen. Dazu kann die Steuer-Einrichtung 240 eine Nachschlag-Tabelle 241 aufweisen.

Durch die Nachschlag-Tabelle 241 kann das an den Spiegel 200 anzulegenden Bias-Potential VB ermittelt werden. Die Steuer-Einrichtung 240 kann auch als Regel-Einrichtung mit mindestens einem Sensor (nicht gezeigt) ausgebildet sein. Details hierzu ergeben sich aus dem in Bezug genommenen Dokument DE 10 2013 209 442 A1.

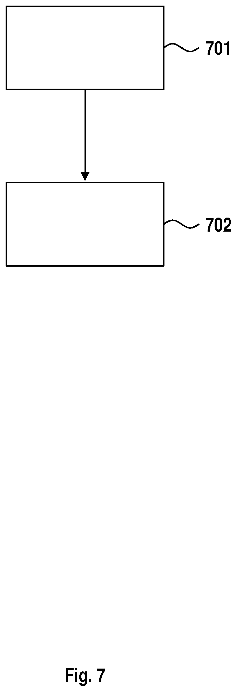

In Fig. 7 ist eine Ausführungsform eines Verfahrens zum Betreiben einer Lithographieanlage 100 dargestellt. Beispiele und Aspekte einer solchen Lithographieanlage 100 sind in den Figs. 1 bis 6 dargestellt. Die Lithographieanlage 100 weist zumindest eine Strahlungsquelle 106A zur Erzeugung einer Strahlung mit einer bestimmten Repetitionsfrequenz f1, ein optisches Bauteil 200, beispielsweise einen Spiegel oder Einzelspiegel, zur Führung der Strahlung in der Lithographieanlage 100, eine Aktuator-Einrichtung 210 zur Verlagerung des optischen Bauteils 200, sowie eine Mess-Einrichtung 230 zum Ermitteln einer Position des optischen Bauteils 200 auf.

Das Verfahren der Fig. 7 weist die Schritte 701 und 702 auf:

In Schritt 701 wird eine Messsignalfrequenz f2 für ein Messsignal S2, mittels dem die Mess-Einrichtung 230 die Position des optischen Bauteils 200 ermitteln kann, derart gewählt, dass die Messsignalfrequenz f2 ungleich der Repetitionsfrequenz f1 der Strahlungsquelle 106A und ungleich ganzzahligen Vielfachen dieser Repetitionsfrequenz f1 ist.

In Schritt 702 wird die Position des optischen Bauteils 200 durch die Mess-Einrichtung 210 mittels des Messsignals S2 mit der gewählten Messsignalfrequenz f2 ermittelt.

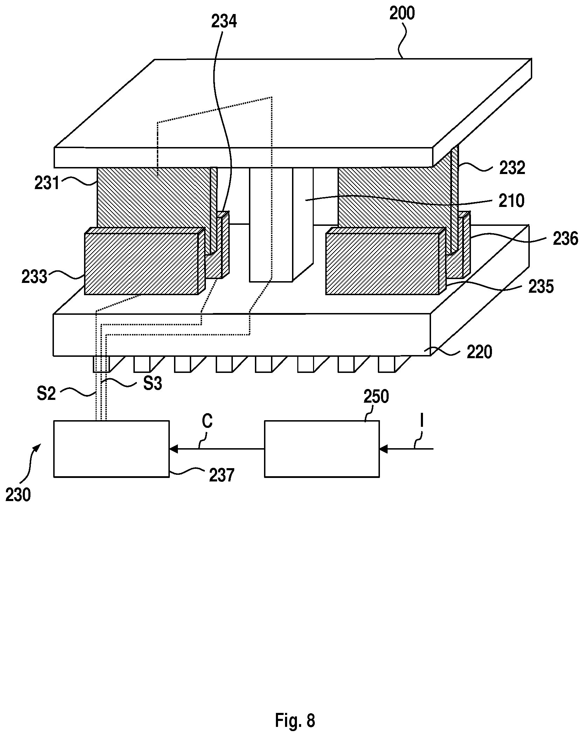

Fig. 8 zeigt eine schematische Ansicht einer vierten Ausführungsform eines Aspekts der EUV-Lithographieanlage 100. Dabei zeigt die Fig. 8 einen Spiegel 200 als optisches Bauteil und eine dem Spiegel 200 zugeordnete Mess-Einrichtung 230. Die Mess-Einrichtung 230 ist insbesondere wie zur Fig. 2 beschrieben ausgebildet. Der Spiegel 200 kann als Einzelspiegel bzw. als MEMS-Spiegel ausgebildet sein und beispielsweise Teil eines der Spiegel 110, 112, 114, 116, 118 des Strahlformungs- und Beleuchtungssystems 102 der EUV-Lithographieanlage 100 der Fig. 1 sein. Der Einzelspiegel 200 der Fig. 8 kann auch Teil eines der weiteren Spiegel M1-M6 der EUV-Lithographieanlage 100 der Fig. 1 sein.

Ferner illustriert die Fig. 8, dass der Spiegel 200 über eine Aufhängung 210 mit einer Basisplatte 220 verbunden ist. Die Aufhängung 210 ist Teil einer nicht näher dargestellten Aktuator-Einrichtung 210 zur Verlagerung des Spiegels 200. Details für ein Beispiel einer solchen Aktuator-Einrichtung 210 ergeben sich aus dem Dokument DE 10 2013 442 A1.

Ferner umfasst die Lithographieanlage 100 gemäß Fig. 8 eine Synchronisations-Einrichtung 250. Die Synchronisations-Einrichtung 250 empfängt eine aktuelle Information I über die von der Strahlungsquelle 106A erzeugte Strahlung und passt das Messsignal S2 und/oder das Anregungssignal S3 in Abhängigkeit der empfangenen aktuellen Information I mittels eines Steuersignals C an. Damit ist die Synchronisations-Einrichtung 250 dazu eingerichtet, das Messsignal S2 und die von der Strahlungsquelle 106A erzeugte Strahlung S1 zeitlich zu synchronisieren.

Beispielsweise kann die Synchronisations-Einrichtung 250 dazu eingerichtet werden, eine Amplitude des Messsignals S2, eine Phase des Messsignals S2 und/oder die Messsignalfrequenz f2 des Messsignals S2 in Abhängigkeit der empfangenen aktuellen Information I anzupassen. In Abhängigkeit der empfangenen aktuellen Information I kann die Synchronisations-Einrichtung 250 mittels des Steuersignals C die Messsignalfrequenz f2 auch derart einstellen, dass sie ungleich der Repetitionsfrequenz f1 der Strahlungsquelle 106A und ungleich ganzzahligen Vielfachen der Repetitionsfrequenz f1 ist.

Des Weiteren kann die Synchronisations-Einrichtung 250 zusätzlich oder alternativ dazu eingerichtet werden, eine Auswertung des Messsignals S2 in Abhängigkeit von der empfangenen aktuellen Information I anzupassen. Beispielsweise kann die Synchronisations-Einrichtung 250 dabei in Abhängigkeit von besagter empfangener aktueller Information I bestimmte Bereiche des Messsignals S2 bei der Auswertung des Messsignals S2 maskieren. Dabei werden insbesondere solche Bereiche des Messsignals S2 bei der Auswertung maskiert, über welche durch die aktuelle Information I bekannt ist, dass diese einen Störanteil über einem bestimmten Grenzwert haben.

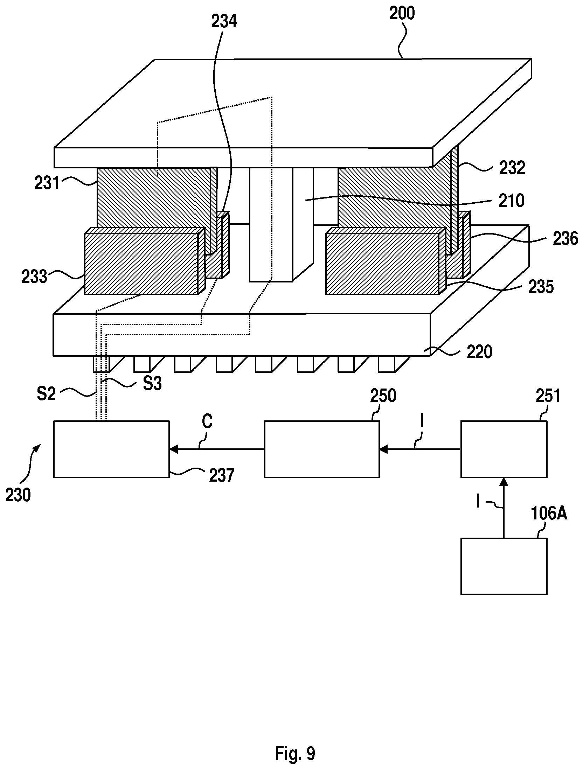

Fig. 9 zeigt eine schematische Ansicht einer fünften Ausführungsform eines Aspekts einer EUV-Lithographieanlage 100 der Fig. 1. Die fünfte Ausführungsform der Fig. 9 basiert auf der vierten Ausführungsform der Fig. 8 und weist sämtliche Merkmale der vierten Ausführungsform der Fig. 8 auf. Darüber hinaus zeigt die Fig. 9, dass die Lithographieanlage 100 eine Übertragungs-Einrichtung 251 aufweist. Die Übertragungs-Einrichtung 251 ist dazu eingerichtet, die aktuelle Information I über die von der Strahlungsquelle 106A erzeugte Strahlung, insbesondere eine Frequenz, eine Phase und/oder eine Amplitude der Strahlung, von der Strahlungsquelle 106A an die Synchronisations-Einrichtung 250 zu übertragen.

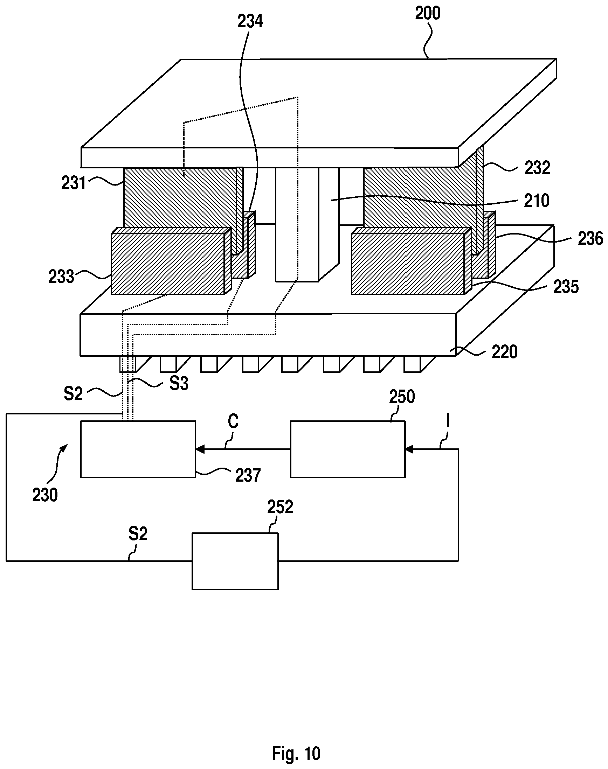

In Fig. 10 ist eine schematische Ansicht einer sechsten Ausführungsform eines Aspekts einer EUV-Lithographieanlage 100 der Fig. 1 dargestellt.

Die sechste Ausführungsform der Fig. 10 basiert auf der vierten Ausführungsform der Fig. 8 und weist sämtliche Merkmale der vierten Ausführungsform der Fig. 8 auf. Darüber hinaus zeigt die Fig. 10, dass die Lithographieanlage 100 eine Extraktionseinheit 252 aufweist. Die Extraktionseinheit 252 ist dazu eingerichtet, die aktuelle Information I über die von der Strahlungsquelle 106A erzeugte Strahlung S1 aus einem Signalanteil, insbesondere einem Störsignalanteil, des Messsignals S2 zu extrahieren.

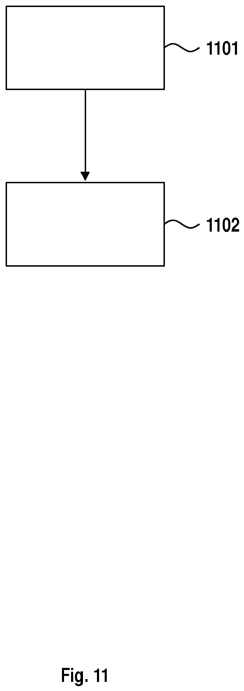

Fig. 11 zeigt eine zweite Ausführungsform eines Verfahrens zum Betreiben einer EUV-Lithographieanlage. Die EUV-Lithographieanlage 100 weist eine Strahlungsquelle 106A zur Erzeugung einer Strahlung mit einer bestimmten Repetitionsfrequenz f1, ein optisches Bauteil 200, beispielsweise einen Spiegel oder Einzelspiegel, zur Führung der Strahlung in der Lithographieanlage 100, eine Aktuator-Einrichtung 210 zur Verlagerung des optischen Bauteils 200 sowie eine Mess-Einrichtung 230 zum Ermitteln einer Position des optischen Bauteils 200 mittels eines Messsignals S2 auf.

Das Verfahren der Fig. 11 weist die Schritte 1101 und 1102 auf:

In Schritt 1101 werden die erzeugte Strahlung S1 und das Messsignal S2 erfasst oder ermittelt.

In Schritt 1102 werden das Messsignal S2 und die von der Strahlungsquelle 106A erzeugte Strahlung S1 zeitlich synchronisiert.

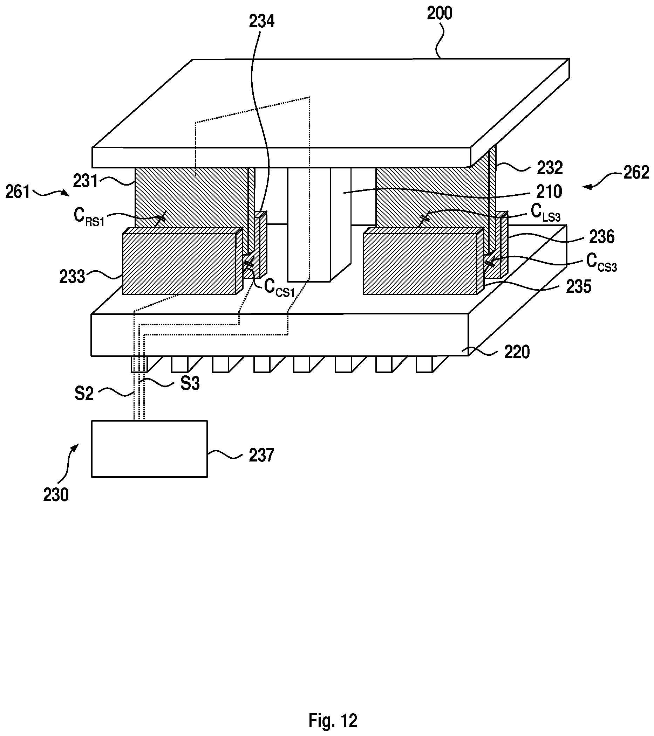

In Fig. 12 ist eine schematische Ansicht einer siebten Ausführungsform eines Aspekts der Lithographieanlage 100 dargestellt. Das siebte Ausführungsform der Fig. 12 basiert auf der ersten Ausführungsform der Fig. 2. Daneben zeigt die Fig. 12 die Kapazitäten $C_{CS1}$, $C_{CS3}$, $C_{RS1}$, $C_{LS3}$. Die Kapazität $C_{CS1}$ ist die Kapazität zwischen den Elektroden 233 und 234. Die Kapazität $C_{RS1}$ ist die Kapazität zwischen den Elektroden 231 und 233. Die Kapazität $C_{CS3}$ ist die Kapazität zwischen den Elektroden 235 und 236. Die Kapazität $C_{LS3}$ ist die Kapazität zwischen den Elektroden 232 und 235. Die Elektroden 231, 233 und 234 bilden eine kammartige erste Sensoreinrichtung 261. Entsprechend bilden die Elektroden 232, 235 und 236 eine kammartige zweite Sensoreinrichtung 262. Die beiden Sensoreinrichtungen 261 und 262 bilden einen kapazitiven Sensor zur Messung der Position eines Kippwinkels des optischen Bauteils 200. Unabhängig voneinander kann mit jeder der Sensoreinrichtungen 261, 261 eine Lageänderung des optischen Bauteils 200 erfasst werden. Im Weiteren wird detailliert nur auf die linke kammartige Sensoreinrichtung 261 eingegangen.

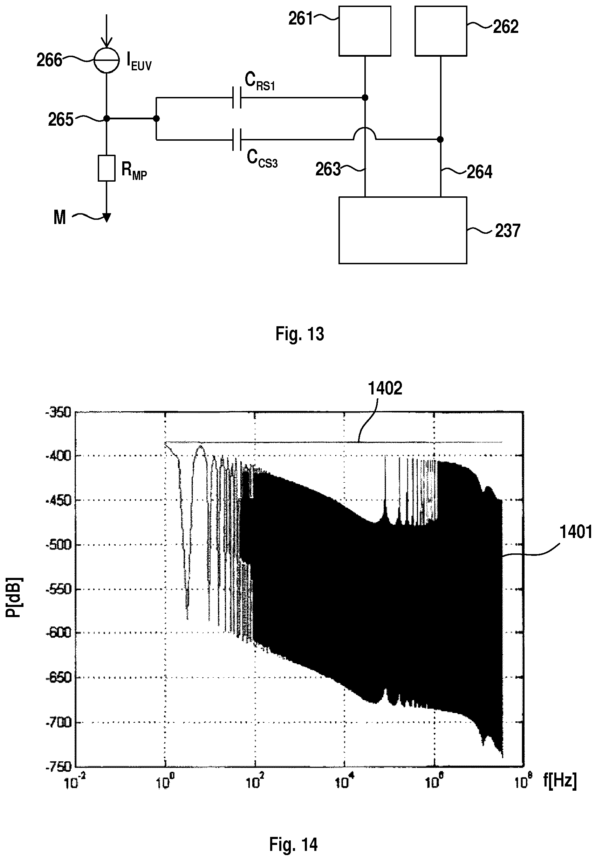

Hierzu zeigt die Fig. 13 ein vereinfachtes elektrisches Ersatzschaltbild für die Anordnung der Fig. 12. Die in der Fig. 13 dargestellte Stromquelle 266 modelliert den durch die Photonen der EUV-Strahlungsquelle 106 der Lithographieanlage 100 auf dem optischen Bauteil 200 erzeugten Strom $I_{EUV}$. Jede der Sensoreinrichtungen 261, 262 ist über eine elektrische Leitung 263, 264 zur Übertragung des jeweiligen Messsignals S2 mit der Auswerteeinheit 237 gekoppelt.

Ferner illustriert der Widerstand $R_{MP}$ in Fig. 13 den elektrischen Widerstand eines Pfads zwischen der mit dem optischen Bauteil 200 verbundenen Elektrode 231 der ersten Sensoranordnung 261, dem optischen Bauteil 200, der Aufhängung 210 und der elektrischen Ankopplung an die Mess-Einrichtung 230 (für die linke Sensoreinrichtung 261) beziehungsweise den elektrischen Widerstand des Pfads zwischen der mit dem optischen Bauteil 200 verbundenen Elektrode 232 der Sensoreinrichtung 261, dem optischen Bauteil 200, der Aufhängung 219 und der elektrischen Ankopplung an die Mess-Einrichtung 230 (für die reche Sensoreinrichtung 262).

Zwischen dem Widerstand $R_{MP}$ und der Stromquelle 266 zur Bereitstellung des Stroms $I_{EUV}$ befindet sich ein Knoten 265. Der Knoten 265 ist über die Kapazität $C_{RS1}$ an die Leitung 263 gekoppelt. Ferner ist der Knoten 265 über die Kapazität $C_{LS3}$ an die Leitung 264 gekoppelt.

Dabei illustriert die Fig. 13, dass ein möglichst geringer Widerstand $R_{MP}$ dazu geeignet ist, die Strom-Spannungs-Wandlung auf dem optischen Bauteil 200 zu reduzieren und damit Störungen, hervorgerufen durch die Photonen der EUV-Strahlungsquelle 106A, in allen Frequenzbereichen zu minimieren.

Ein Aspekt für den elektrischen Widerstand $R_{MP}$ bzw. dessen Widerstandswert ist die Ausgestaltung der Aufhängung 210. Vorliegend ist die Aufhängung 210 vorzugsweise aus einem dotierten Polysilizium hergestellt, so dass ein geringer beziehungsweise minimaler elektrischer Widerstand $R_{MP}$ bewerkstelligt werden kann. Insbesondere ist die Aufhängung 2010 derart dotiert, dass der elektrische Widerstand $R_{MP}$ des Pfads zwischen der mit dem optischen Bauteil 200 verbundenen Elektrode 231 der ersten Sensoreinrichtung 261, dem optischen Bauteil 200, der Aufhängung 210 und der elektrischen Ankopplung an die Mess-Einrichtung 230 als auch der elektrische Widerstand $R_{MP}$ des Pfads zwischen der mit dem optischen Bauteil 200 verbundenen Elektrode 232 der zweiten Sensoreinrichtung 262, dem optischen Bauteil 200, der Aufhängung 210 und der elektrischen Ankopplung an die Mess-Einrichtung 230 kleiner als 1 kΩ, bevorzugt kleiner als 100 Ω, besonders bevorzugt kleiner als 10 Ω, ist.

Hierzu zeigt Fig. 14 ein Diagramm zur Illustrierung des Leistungsdichtespektrums 1401 einer EUV-bedingten Störung des Messsignals S2 bei einem Widerstand $R_{MP}$ von 10 Ω. Wie die Fig. 14 zeigt, ist das Leistungsdichtespektrum 1401 der EUV-bedingten Störung des Messsignals S2 derart reduziert, dass es unterhalb einer spezifikationsspezifischen Obergrenze 1402 liegt.

Eine achte Ausführungsform eines Aspekts der Lithographieanlage 100 ergibt sich aus der siebten Ausführungsform der Fig. 12 dadurch, dass das optische Bauteil 200 mit einer ersten Schicht und einer von der ersten Schicht mittels eines Dielektrikums getrennten zweiten Schicht ausgebildet wird. Dabei ist die erste Schicht insbesondere eine Spiegelschicht und die zweite Schicht ist zur elektrischen Kopplung mit dem kapazitiven Sensor, insbesondere mit den Elektroden 231, 232, eingerichtet. Die erste Schicht und die zweite Schicht des optischen Bauteils 200 sind insbesondere jeweils mit einem gemeinsamen Bezugspotential elektrisch gekoppelt. Das gemeinsame Bezugspotential ist beispielsweise Masse.

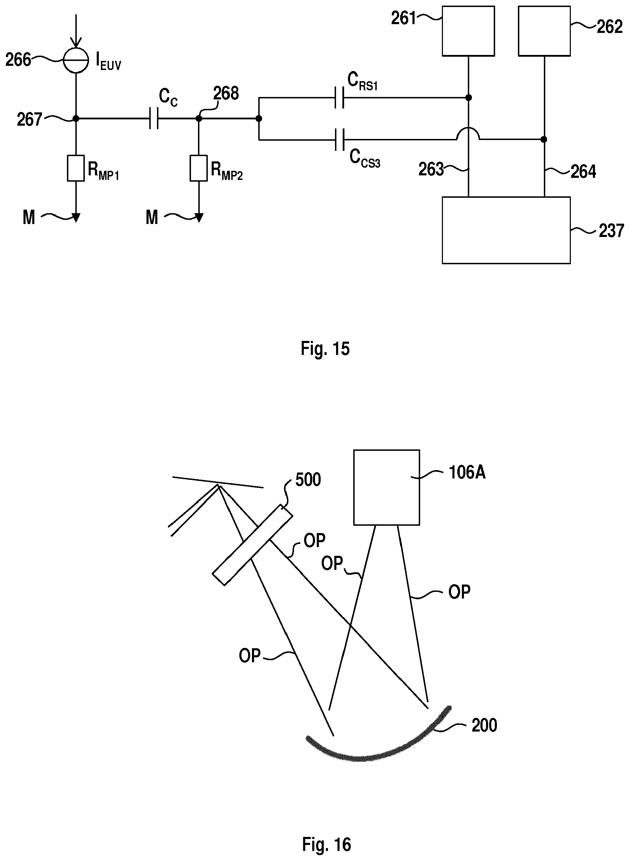

Hierzu zeigt die Fig. 15 ein vereinfachtes elektronisches Ersatzschaltbild für diese achte Ausführungsform der Anordnung basierend auf der Fig. 12 und der Ausbildung des optischen Bauteils mit zwei getrennten Schichten. In Fig. 15 bezeichnet $R_{MP1}$ den elektrischen Widerstand des Pfads zwischen dem Dielektrikum, elektrisch abgebildet in Fig. 15 durch die Koppelkapazität $C_C$, der Aufhängung 210 und der elektrischen Ankopplung an die Mess-Einrichtung 230. Entsprechend modelliert der elektrische Widerstand $R_{MP2}$ in Fig. 15 den elektrischen Widerstand des Pfads zwischen der zweiten Schicht des optischen Bauteils 200, der Aufhängung 210

und der elektrischen Ankopplung an die Mess-Einrichtung 230. Dabei illustriert die Fig. 15, dass die Koppelkapazität $C_C$ und der elektrische Widerstand $R_{MP2}$ ein Hochpassfilter ausbilden. Das Hochpassfilter ist dazu eingerichtet, niederfrequente EUV-Störungen zu filtern.

In Fig. 16 ist eine schematische Ansicht einer neunten Ausführungsform eines Aspekts der Lithographieanlage 100 dargestellt. Bei der neunten Ausführungsform der Lithographieanlage 100 der Fig. 16 ist die Lithographieanlage kontinuierlich eingeschaltet beziehungsweise kontinuierlich betrieben und erzeugt eine Strahlung mit einer bestimmten Repetitionsfrequenz f1. Das optische Bauteil 200 der Fig. 16 ist dazu eingerichtet, die Strahlung in der Lithographieanlage 100 gemäß einem vorbestimmten optischen Pfad OP zu führen. Außerdem umfasst die Lithographieanlage 100 eine Aktuator-Einrichtung 210 zur Verlagerung des optischen Bauteils 200 (nicht gezeigt in Fig. 16) sowie eine Mess-Einrichtung 230 zum Ermitteln einer Position des optischen Bauteils 200 mittels eines Messsignals S2 mit einer bestimmten Messsignal-Frequenz f2 (nicht gezeigt in Fig. 16).

Gemäß Fig. 16 ist eine dem optischen Bauteil 200 im optischen Pfad OP der Lithographieanlage 100 nachgeordnete Vorrichtung 500 zum Öffnen und Unterbrechen des optischen Pfads angeordnet. Die Vorrichtung 500 hat die Funktionalität, den optischen Pfad OP gemäß einer vorbestimmten Frequenz, zum Beispiel 6 Hz, zu öffnen und zu unterbrechen und damit dem Ausgang der Vorrichtung 500 eine Strahlung mit der bestimmten Repetitionsfrequenz f1 bereitzustellen, die gemäß der vorbestimmten Frequenz von 6 Hz eingeschaltet und ausgeschaltet ist. Hierbei übernimmt die Vorrichtung 500 die Funktion eines On-Off-Keyings. Durch die Verwendung der Vorrichtung 500 kann die Strahlungsquelle 106A kontinuierlich eingeschaltet bleiben, so dass das optische Bauteil 200 und die mit dem optischen Bauteil 200 gekoppelte Mess-Einrichtung 230 die kontinuierliche Strahlung der kontinuierlich eingeschalteten Strahlungsquelle 106A sehen und damit niederfrequente Teile in dem Leistungsdichtespektrum nicht auftreten werden. Beispielsweise ist die Vorrichtung 500 zum Öffnen und Unterbrechen des optischen Pfads OP in einer Shutter-Einrichtung (nicht gezeigt) integriert.

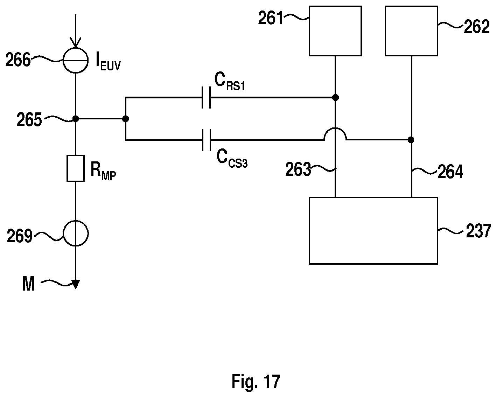

Eine zehnte Ausführungsform eines Aspekts der Lithographieanlage 100 ergibt sich aus der neunten Ausführungsform gemäß Fig. 16 dadurch, dass die Strahlungsquelle 106A nur zu bestimmten Einschaltzeiten periodisch eingeschaltet wird. In dieser Ausführungsform wird eine Spannungsquelle 269 mit dem optischen Bauteil 200 gekoppelt. Ein vereinfachtes elektronisches Ersatzschaltbild hierzu zeigt die Fig. 17. Das elektronisches Ersatzschaltbild der Fig. 17 basiert auf dem elektronischen Ersatzschaltbild der Fig. 13 und umfasst zusätzlich die Spannungsquelle 269, welche zwischen Widerstand $R_{MP}$ und Masse M gekoppelt ist. Die Spannungsquelle 269 ist dazu eingerichtet, die durch die von Strahlung der Strahlungsquelle 106A zu den bestimmten Einschaltzeiten an den optischen Bauteil 200 erzeugten Störpulse außerhalb der bestimmten Einschaltzeit hin zu emulieren. Damit sieht die mit dem optischen Bauteil 200 gekoppelte Mess-Einrichtung 230 eine der Fig. 16 entsprechendes Störspektrum, so dass auch hier niederfrequente Teile in dem Leistungsdichtespektrum nicht auftreten werden. Insbesondere ist dabei die Spannungsquelle 269 dazu eingerichtet, die Störpulse außerhalb der bestimmten Einschaltzeiten mit der bestimmten Repetitionsfrequenz f1 der Strahlungsquelle 106A zu emulieren.

Obwohl die vorliegende Erfindung anhand von Ausführungsbeispielen beschrieben wurde, ist sie vielfältig modifizierbar. Die Erfindung wird durch die Ansprüche definiert.

BEZUGSZEICHENLISTE

| | |
|---|---|
| 100 | Lithographieanlage |
| 100A | EUV-Lithographieanlage |
| 102 | Strahlformungs- und Beleuchtungssystem |
| 104 | Projektionssystem |
| 106A | Strahlungsquelle, EUV-Lichtquelle |
| 108A | EUV-Strahlung |
| 110 | Spiegel |
| 112 | Spiegel |
| 114 | Spiegel |
| 116 | Spiegel |
| 118 | Spiegel |
| 120 | Photomaske |
| 122 | Wafer |
| 124 | optische Achse des Projektionssystems |
| 136 | Spiegel |
| M1-M6 | Spiegel |
| 137 | Vakuum-Gehäuse |
| 200 | Spiegel |
| 210 | Aktuator-Einrichtung, insbesondere Aufhängung |
| 220 | Basisplatte |
| 230 | Mess-Einrichtung |
| 231 | Elektrode |
| 232 | Elektrode |
| 233 | Elektrode |
| 234 | Elektrode |
| 235 | Elektrode |
| 236 | Elektrode |
| 237 | Auswerteeinheit |
| 238 | Einstell-Einrichtung |
| 239 | Speicher-Einrichtung |
| 240 | Steuer-Einrichtung |
| 250 | Synchronisations-Einrichtung |
| 251 | Übertragungs-Einrichtung |
| 252 | Extraktionseinheit |
| 261 | Sensoreinrichtung |
| 262 | Sensoreinrichtung |
| 263 | Leitung |

| | |
|---|---|
| 264 | Leitung |
| 265 | Knoten |
| 266 | Stromquelle |
| 267 | Knoten |
| 268 | Knoten |
| 269 | Spannungsquelle |
| 401 | Signal-Rausch-Verhältnis |
| 402 | Untergrenze des Signal-Rauschverhältnisses |
| 403 | maximale Grenzfrequenz der Anregungsfrequenz |
| 404 | mögliche Werte der Messsignalfrequenz |
| 500 | Vorrichtung zum Öffnen und Unterbrechen des optischen Pfads |
| 701 | Verfahrensschritt |
| 702 | Verfahrensschritt |
| 1101 | Verfahrensschritt |
| 1102 | Verfahrensschritt |
| 1401 | Leistungsdichtespektrum einer EUV-bedingten Störung des Messsignals |
| 1402 | Obergrenze |
| A | Amplitude |
| B | Bandbreite |
| C | Steuersignal |
| $C_C$ | Kapazität zwischen erster Schicht und zweiter Schicht des optischen Bauelements |
| $C_{RS1}$ | Kapazität zwischen Elektrode 231 und Elektrode 233 |
| $C_{LS3}$ | Kapazität zwischen Elektrode 232 und Elektrode 235 |
| $C_{CS1}$ | Kapazität zwischen Elektrode 233 und Elektrode 234 |
| $C_{CS3}$ | Kapazität zwischen Elektrode 235 und Elektrode 236 |
| f | Frequenz |
| f1 | Frequenz der EUV-Strahlung |
| f2 | Messsignalfrequenz |
| f3 | Anregungssignalfrequenz |
| I | Information |
| M | Bezugspotential |
| OP | optischer Pfad |
| $R_{MP}$ | Widerstand |
| S1 | EUV-Strahlung |
| S2 | Messsignal |
| S3 | Anregungssignal |
| VB | Bias-Potential |

**Patentansprüche**

1. Lithographieanlage (100), mit:

   einer Strahlungsquelle (106A) zur Erzeugung einer Strahlung mit einer bestimmten Repetitionsfrequenz (f1),
   einem optischen Bauteil (200) zur Führung der Strahlung in der Lithographieanlage (100),
   einer Aktuator-Einrichtung (210) zur Verlagerung des optischen Bauteils (200),

einer Mess-Einrichtung (230) zum Ermitteln einer Position des optischen Bauteils (200) mittels eines Messsignals (S2) mit einer bestimmten Messsignalfrequenz (f2), wobei die Messsignalfrequenz (f2) ungleich der Repetitionsfrequenz (f1) und ungleich ganzzahligen Vielfachen der Repetitionsfrequenz (f1) ist, und

einer Einstell-Einrichtung (238) eingerichtet dazu, die Messsignalfrequenz (f2) in Abhängigkeit von der Repetitionsfrequenz (f1) einzustellen.

2. Lithographieanlage gemäß Anspruch 1, wobei |f2 - n·f1| > B ist, wobei f1 die Repetitionsfrequenz, f2 die Messsignalfrequenz, n ganzzahlige Vielfache der Repetitionsfrequenz f1 und B eine vorbestimmte Bandbreite bezeichnet.

3. Lithographieanlage gemäß Anspruch 1 oder 2, wobei die Messsignalfrequenz (f2) ungleich der Repetitionsfrequenz (f1), ungleich den ganzzahligen Vielfachen der Repetitionsfrequenz (f1) und kleiner als eine maximale Grenzfrequenz für die Messsignalfrequenz (f2) ist.

4. Lithographieanlage gemäß einem der Ansprüche 1 bis 3, wobei zwischen der Messsignalfrequenz (f2) und der Repetitionsfrequenz (f1) sowie zwischen der Messsignalfrequenz (f2) und einem jeweiligen ganzzahligen Vielfachen der Repetitionsfrequenz (f1) jeweils zumindest eine vorbestimmte Bandbreite (B) vorgesehen ist.

5. Lithographieanlage gemäß einem der Ansprüche 1 bis 4, wobei die Messsignalfrequenz (f2) eine Abtastfrequenz ist, wobei die Mess-Einrichtung (230) dazu eingerichtet ist, das optische Bauteil (200) und mit dem optischen Bauteil (200) verbundene Elektroden (231 - 236) mit der Abtastfrequenz (f2) abzutasten.

6. Lithographieanlage gemäß einem der Ansprüche 1 bis 5, mit:
einer Steuer-Einrichtung (240) zur gezielten Beaufschlagung des optischen Bauteils (200) mit einem elektrischen Bias-Potential (VB).

7. Lithographieanlage gemäß Anspruch 6, wobei die Steuer-Einrichtung (240) als Regel-Einrichtung mit mindestens einem Sensor ausgebildet ist.

8. Lithographieanlage gemäß einem der Ansprüche 1 bis 7, wobei die Strahlungsquelle (106A) eine EUV-Strahlungsquelle ist, welche zur Erzeugung einer EUV-Strahlung mit der vorbestimmten Repetitionsfrequenz (f1) eingerichtet ist.

9. Lithographieanlage gemäß einem der Ansprüche 1 bis 8, wobei die Mess-Einrichtung (230) einen kapazitiven Sensor zur Messung der Position eines Kippwinkels des optischen Bauteils (200) aufweist.

10. Lithographieanlage gemäß einem der Ansprüche 1 bis 9, wobei die Aktuator-Einrichtung (210) eine Aufhängung zur Lagerung des optischen Bauteils (200) über einer Basisplatte (220) umfasst, wobei die Aufhängung derart ausgebildet ist, dass der elektrische Widerstand eines Pfads zwischen der mit dem optischen Bauteil (200) verbundenen Elektrode (231) des kapazitiven Sensors, dem optischen Bauteil (200), der Aufhängung (210) und der elektrischen Ankopplung an die Mess-Einrichtung (230) kleiner als 1 kΩ, bevorzugt kleiner als 100 Ω, besonders bevorzugt kleiner als 10 Ω ist.

11. Lithographieanlage gemäß Anspruch 10, wobei die Aufhängung zur Lagerung des optischen Bauteils (200) aus einem dotierten Halbleitermaterial hergestellt ist.

12. Lithographieanlage gemäß einem der Ansprüche 1 bis 11, wobei die Mess-Einrichtung (230) dazu eingerichtet ist, das optische Bauteil (200) und die mit dem optischen Bauteil (200) verbundenen Elektroden (231 - 236) mit einem Anregungssignal (S3) mit einer vorbestimmten Anregungsfrequenz (f3) und einem vorbestimmten Spannungswert größer 3,3 V und kleiner gleich 20 V anzuregen und anschließend mit der Abtastfrequenz (f2) abzutasten, wobei die Anregungsfrequenz (f3) gleich der Abtastfrequenz (f2) ist.

13. Lithographieanlage gemäß einem der Ansprüche 1 bis 12, wobei das optische Bauteil (200) eine erste Schicht und eine von der ersten Schicht mittels eines Dielektrikums getrennte zweite Schicht aufweist, wobei die erste Schicht eine Spiegelschicht ist und die zweite Schicht zur elektrischen Kopplung mit dem kapazitiven Sensor eingerichtet ist.

14. Lithographieanlage gemäß Anspruch 13, wobei ein elektrischer Widerstand eines Pfads zwischen dem Dielektrikum und dem Bezugspotential über die zweite Schicht und eine durch die erste Schicht, das Dielektrikum und die zweite Schicht gebildete Kapazität ein Hochpassfilter ausbilden.

15. Verfahren zum Betreiben einer Lithographieanlage (100) aufweisend eine Strahlungsquelle (106A) zur Erzeugung einer Strahlung mit einer bestimmten Repetitionsfrequenz (f1), ein optisches Bauteil (200) zur Führung der Strahlung in der Lithographieanlage (100), eine Aktuator-Einrichtung (210) zur Verlagerung des optischen Bauteils (200) und eine Mess-Einrichtung (230) zum Ermitteln einer Position des optischen Bauteils (200), mit:

Ermitteln der Position des optischen Bauteils (200) durch die Mess-Einrichtung (210) mittels eines Messsignals (S2) mit einer bestimmten Messsignalfrequenz (f2),

Einstellen der Messsignalfrequenz (f2) in Abhängigkeit von der Repetitionsfrequenz (f1) mittels einer Einstell-Einrichtung (238) derart, dass die Messsignalfrequenz (f2) ungleich der Repetitionsfrequenz (f1) und ungleich ganzzahligen Vielfachen der Repetitionsfrequenz (f1) ist.

**Claims**

1. Lithography apparatus (100), comprising:

   a radiation source (106A) for producing radiation having a specific repetition frequency (f1),
   an optical component (200) for guiding the radiation within the lithography apparatus (100),
   an actuator device (210) for displacing the optical component (200),
   a measurement device (230) for determining a position of the optical component (200) using a measurement signal (S2) having a specific measurement signal frequency (f2), wherein the measurement signal frequency (f2) is unequal to the repetition frequency (f1) and unequal to integer multiples of the repetition frequency (f1), and a setting device (238) configured to set the measurement signal frequency (f2) in dependence on the repetition frequency (f1).

2. Lithography apparatus according to Claim 1, wherein |f2 - n · f1| > B, wherein f1 designates the repetition frequency, f2 designates the measurement signal frequency, n designates integer multiples of the repetition frequency f1, and B designates a predetermined bandwidth.

3. Lithography apparatus according to Claim 1 or 2, wherein the measurement signal frequency (f2) is unequal to the repetition frequency (f1), unequal to the integer multiples of the repetition frequency (f1), and less than a maximum cut-off frequency for the measurement signal frequency (f2).

4. Lithography apparatus according to one of Claims 1 to 3, wherein in each case at least one predetermined bandwidth (B) is provided between the measurement signal frequency (f2) and the repetition frequency (f1) and between the measurement signal frequency (f2) and a respective integer multiple of the repetition frequency (f1).

5. Lithography apparatus according to one of Claims 1 to 4, wherein the measurement signal frequency (f2) is a sampling frequency, wherein the measurement device (230) is configured to sample the optical component (200) and electrodes (231 - 236), which are connected to the optical component (200), with the sampling frequency (f2).

6. Lithography apparatus according to one of Claims 1 to 5, comprising:
   a control device (240) for the targeted application of an electrical bias potential (VB) to the optical component (200).

7. Lithography apparatus according to Claim 6, wherein the control device (240) is in the form of a closed-loop control device having at least one sensor.

8. Lithography apparatus according to one of Claims 1 to 7, wherein the radiation source (106A) is an EUV radiation source, which is configured for producing EUV radiation having the predetermined repetition frequency (f1).

9. Lithography apparatus according to one of Claims 1 to 8, wherein the measurement device (230) has a capacitive sensor for measuring the position of a tilt angle of the optical component (200).

10. Lithography apparatus according to one of Claims 1 to 9, wherein the actuator device (210) comprises a suspension for mounting the optical component (200) above a base plate (220), wherein the suspension is configured such that the electrical resistance of a path between the electrode (231), which is connected to the optical component (200), of the capacitive sensor, the optical component (200), the suspension (210) and the electrical coupling to the measurement device (230) is less than 1 kΩ, preferably less than 100 Ω, particularly preferably less than 10 Ω.

11. Lithography apparatus according to Claim 10, wherein the suspension for mounting the optical component (200) is made from a doped semiconductor material.

12. Lithography apparatus according to one of Claims 1 to 11, wherein the measurement device (230) is configured to excite the optical component (200) and the electrodes (231 - 236), which are connected to the optical component (200), with an excitation signal (S3) having a predetermined excitation frequency (f3) and a predetermined voltage value of greater than 3.3 V and less than or equal to 20 V and to subsequently sample them with the sampling frequency (f2), with the excitation frequency (f3) being equal to the sampling frequency (f2).

13. Lithography apparatus according to one of Claims 1 to 12, wherein the optical component (200) has a first layer and a second layer, separated from the first layer by way of a dielectric, wherein the first layer is a mirror layer and the second layer is configured for electric coupling to the capacitive sensor.

14. Lithography apparatus according to Claim 13, wherein an electrical resistance of a path between the dielectric and the reference potential via the second layer and a capacitance, formed by the first layer, the dielectric and the second layer, form a high-pass filter.

15. Method for operating a lithography apparatus (100), having a radiation source (106A) for producing radiation having a specific repetition frequency (f1), an optical component (200) for guiding the radiation within the lithography apparatus (100), an actuator device (210) for displacing the optical component (200), and a measurement device (230) for determining a position of the optical component (200), comprising:

determining the position of the optical component (200) by the measurement device (210) using a measurement signal (S2) having a specific measurement signal frequency (f2),
setting the measurement signal frequency (f2) in dependence on the repetition frequency (f1) by means of a setting device (238) such that the measurement signal frequency (f2) is unequal to the repetition frequency (f1) and unequal to integer multiples of the repetition frequency (f1).

**Revendications**

1. Installation lithographique (100), comprenant :

une source de rayonnement (106A) servant à générer un rayonnement à une fréquence de répétition définie (f1),
un composant optique (200) servant à guider le rayonnement dans l'installation lithographique (100),
un système d'actionnement (210) servant à déplacer le composant optique (200),
un système de mesure (230) servant à déterminer une position du composant optique (200) au moyen d'un signal de mesure (S2) ayant une fréquence (f2) de signal de mesure définie, dans laquelle la fréquence (f2) du signal de mesure est différente de la fréquence de répétition (f1) et différente d'un multiple entier de la fréquence de répétition (f1), et
un système de réglage (238) conçu pour régler la fréquence (f2) du signal de mesure en fonction de la fréquence de répétition (f1).

2. Installation lithographique selon la revendication 1, dans laquelle |f2 - n·f1| > B, où f1 est la fréquence de répétition, f2 est la fréquence du signal de mesure, n est un multiple entier de la fréquence de répétition f1 et B est une largeur de bande prédéfinie.

3. Installation lithographique selon la revendication 1 ou 2, dans laquelle la fréquence (f2) du signal de mesure est différente de la fréquence de répétition (f1), différente du multiple entier de la fréquence de répétition (f1), et inférieure à une fréquence de coupure maximale pour la fréquence (f2) du signal de mesure.

4. Installation lithographique selon l'une des revendications 1 à 3, dans laquelle il est respectivement prévu au moins une largeur de bande (B) prédéfinie entre la fréquence (f2) du signal de mesure et la fréquence de répétition (f1) et entre la fréquence (f2) du signal de mesure et un multiple entier respectif de la fréquence de répétition (f1).

5. Installation lithographique selon l'une des revendications 1 à 4, dans laquelle la fréquence (f2) du signal de mesure est une fréquence de balayage, dans laquelle le système de mesure (230) est conçu pour balayer à la fréquence de balayage (f2) le composant optique (200) et des électrodes (231 - 236) reliées au composant optique (200).

6. Installation lithographique selon l'une des revendications 1 à 5, comprenant :
un système de commande (240) servant à appliquer de manière ciblée un potentiel de polarisation électrique (VB) au composant optique (200).

7. Installation lithographique selon la revendication 6, dans laquelle le système de commande (240) est réalisé sous la forme d'un système de commande comportant au moins un capteur.

8. Installation lithographique selon l'une des revendications 1 à 7, dans laquelle la source de rayonnement (106A) est une source de rayonnement EUV qui est conçue pour générer un rayonnement EUV à la fréquence de répétition (f1) prédéfinie.

9. Installation lithographique selon l'une des revendications 1 à 8, dans laquelle le système de mesure (230) comporte un capteur capacitif servant à mesurer la position d'un angle d'inclinaison du composant optique (200).

10. Installation lithographique selon l'une des revendications 1 à 9, dans laquelle le système d'actionnement (210) comprend une suspension servant à supporter le composant optique (200) au-dessus d'une plaque de base (220), dans laquelle la suspension est réalisée de manière à ce que la résistance électrique d'un trajet entre l'électrode (231) du capteur capacitif qui est reliée au composant optique (200), le composant optique (200), la suspension (210) et le raccordement électrique au système de mesure (230) soit inférieure à 1 k□ préférablement inférieure à 100 □, et de manière particulièrement préférable, inférieure à 10 □.

11. Installation lithographique selon la revendication 10, dans laquelle la suspension servant à monter le composant optique (200) est constituée d'un matériau semi-conducteur dopé.

12. Installation lithographique selon l'une des revendications 1 à 11, dans laquelle le système de mesure (230) est conçu pour exciter le composant optique (200) et les électrodes (231 - 236) reliées au composant optique (200) avec un signal d'excitation (S3) ayant une fréquence d'excitation (f3) prédéfinie et une valeur de tension prédéfinie supérieure à 3,3 V et inférieure ou égale à 20 V, puis pour effectuer un balayage à la fréquence de balayage (f2), dans laquelle la fréquence d'excitation (f3) est égale à la fréquence de balayage (f2).

13. Installation lithographique selon l'une des revendications 1 à 12, dans laquelle le composant optique (200) comporte une première couche et une seconde couche séparées de la première couche au moyen d'un diélectrique, dans laquelle la première couche est une couche miroir et la seconde couche est conçue pour le couplage électrique avec le capteur capacitif.

14. Installation lithographique selon la revendication 13, dans laquelle une résistance électrique d'un trajet entre le diélectrique et le potentiel de référence par l'intermédiaire de la seconde couche et une capacité formée par la première couche, le diélectrique et la seconde couche constituent un filtre passe-haut.

15. Procédé de fonctionnement d'une installation lithographique (100) comportant une source de rayonnement (106A) servant à générer un rayonnement à une fréquence de répétition (f1) prédéfinie, un composant optique (200) servant à guider le rayonnement dans l'installation lithographique (100), un système d'actionnement (210) servant à déplacer le composant optique (200) et un système de mesure (230) servant à déterminer une position du composant optique (200), comprenant :

la détermination de la position du composant optique (200) par le système de mesure (210) au moyen d'un signal de mesure (S2) ayant une fréquence (f2) de signal de mesure définie,
le réglage de la fréquence (f2) du signal de mesure en fonction de la fréquence de répétition (f1) au moyen d'un système de réglage (238) de manière à ce que la fréquence (f2) du signal de mesure soit différente de la fréquence de répétition (f1) et différente d'un multiple entier de la fréquence de répétition (f1).

Fig. 1

Fig. 2

Fig. 3

Fig. 4

Fig. 5

**Fig. 6**

Fig. 7

Fig. 8

Fig. 9

Fig. 10

Fig. 11

Fig. 12

Fig. 13

Fig. 14

Fig. 15

Fig. 16

Fig. 17

**IN DER BESCHREIBUNG AUFGEFÜHRTE DOKUMENTE**

**In der Beschreibung aufgeführte Patentdokumente**

- WO 2009100856 A1
- DE 102013209442 A1
- US 20140226141 A1
- US 2008079930 A1
- US 2009262324 A1
- WO 2010049076 A1
- DE 102013442 A1